# EUROPEAN PATENT APPLICATION

(11) **EP 4 539 502 A1**
(43) Date of publication of application: **16.04.2025**
(21) Application number: 23850221.5
(22) Date of filing: 02.06.2023
(51) Int. Cl.: H04R 3/02, H03F 3/217, H03F 1/02

(54) **AUDIO DEVICE INCLUDED IN ELECTRONIC DEVICE, AND CONTROL METHOD THEREOF**

(30) Priority: 04.08.2022 KR 20220097602; 30.08.2022 KR 20220109393
(71) Applicant: Samsung Electronics Co., Ltd., Suwon-si, Gyeonggi-do 16677 (KR)
(72) Inventor: LEE, Sangjun, Suwon-si, Gyeonggi-do 16677 (KR); NA, Hyoseok, Suwon-si, Gyeonggi-do 16677 (KR); LEE, Seunghyuk, Suwon-si, Gyeonggi-do 16677 (KR)
(74) Representative: HGF
(86) International application number: PCT/KR2023/007595
(87) International publication number: WO 2024/029711

(57) **Abstract**

An embodiment of the present disclosure relates to an audio device for blocking noise generated in an idle state in an electronic device. The audio device may include a processor configured to output an audio signal. The audio device may include an audio amplifier configured to amplify and output the audio signal output from the processor through an interface electrically connected to the processor. The audio device may include a switching part configured to, in response to a switching control signal, switch the amplified audio signal output from the audio amplifier, into an acoustic output. The audio device may include the acoustic output configured to output, to the outside, the amplified audio signal transferred through the switching part. The audio device may include a rectifier configured to output the switching control signal for enabling the switching part if there is the audio signal transferred from the processor to the audio amplifier through the interface.

## Description

### [Technical Field]

The disclosure relates to an audio device and control method thereof to block audible noise in an electronic device.

### [Background Art]

In general, electronic devices, such as smartphones, smart pads, tablet PCs or multimedia players, may have functions that allow users to use multimedia services, such as music or video, or provide voice or video call communication services. When the user uses a multimedia service or a communication service, sound may be output through an output means, such as a built-in speaker or receiver, or through earphones connected to an ear jack or port (e.g., type-C port).

The electronic device may have other components (e.g., cameras, RF modules) or signal lines (e.g., video or RF signal lines) placed or passing near the component that processes the audio signal. In the electronic devices, the other components or signal lines may cause audible noise when the audio signal-processing component is in idle state. The idle state here may be a state where there is no output audio signal.

### [Detailed Description of the Invention]

### [Technical Solution]

The disclosure may provide an audio device and a control method thereof which blocks audible noise in an idle state in which there is no sound signal output in an electronic device.

In the disclosure, an electronic device may comprise an audio device configured to control an output of an audio signal. The audio device may include a processor configured to output an audio signal and an audio amplifier configured to amplify and output the audio signal output from the processor through an interface electrically connecting the processor. The audio device may include a switch part configured to switch the amplified audio signal output from the audio amplifier to a sound output in response to a switching control signal. The audio device may include the sound output configured to output the amplified audio signal transferred through the switch part to an outside. The audio device may include a rectifier configured to output the switching control signal for enabling or disabling the switch part if there is the audio signal transferred from the processor to the audio amplifier through the interface.

In the disclosure, an electronic device may provide a method of operating to control an output of an audio signal. The method may comprise obtaining, by the electronic device, a signal in an interface corresponding to an input for audio amplification. The method may comprise outputting, by the electronic device, outputting an amplified signal using the signal in the interface as an input. The method may comprise connecting, by the electronic device, a path for transferring the amplified signal to an output audio signal by a signal rectified from a signal obtained from the interface.

In the disclosure, an electronic device may comprise a non-transitory computer-readable storage medium storing one or more programs. The one or more programs stored in the computer-readable storage medium may include instructions enabling the electronic device to obtain a signal in an interface corresponding to an input for audio amplification. The one or more programs stored in the computer-readable storage medium may include instructions enabling the electronic device to output an amplified signal using the signal in the interface as an input. The one or more programs stored in the computer-readable storage medium may include instructions enabling the electronic device to connect a path for transferring the amplified signal to an output audio signal by a signal rectified from a signal obtained from the interface.

The technical objects of the disclosure are not limited to the foregoing, and other technical objects may be derived by one of ordinary skill in the art from example embodiments of the disclosure.

According to embodiments of the disclosure, it is possible to provide user convenience by removing noise heard in idle state.

Effects of the present invention are not limited to the foregoing, and other unmentioned effects would be apparent to one of ordinary skill in the art from the following description. In other words, unintended effects in practicing embodiments of the disclosure may also be derived by one of ordinary skill in the art from example embodiments of the disclosure.

### [Brief Description of the Drawings]

FIG. 1 is a view illustrating an electronic device in a network environment according to various embodiments;
FIG. 2 is a block diagram illustrating an audio module according to an embodiment;
FIG. 3 is block diagram illustrating an audio device in an electronic device according to an embodiment of the disclosure;
FIG. 4 is block diagram illustrating an audio device in an electronic device according to an embodiment of the disclosure;
FIG. 5 is a waveform diagram illustrating electrical signals S₁, S₂, S₃, and S₄ flowing through the respective lines of the audio device in FIG. 4;
FIG. 6 is block diagram illustrating an audio device in an electronic device according to an embodiment of the disclosure;
FIG. 7 is a waveform diagram illustrating electrical signals S₁, S₂, S₃, S₄, and S₅ flowing through the respective lines of the audio device in FIG. 6;
FIGS. 8A to 8E are layout views illustrating components included in an audio device in an electronic device according to an embodiment of the disclosure;
FIG. 9A is a block diagram illustrating an audio amplifier included in the audio device of FIG. 8A;
FIG. 9B is a block diagram illustrating an audio amplifier included in the audio device of FIG. 8B;
FIG. 9C is a block diagram illustrating an audio amplifier included in the audio device of FIG. 8C or 8D;
FIG. 9D is a block diagram illustrating an audio amplifier included in the audio device of FIG. 8E;
FIG. 10 is a circuit diagram illustrating a rectifier included in the audio device of FIGS. 8A to 8E;
FIG. 11 is a circuit diagram illustrating a switch part included in the audio device of FIGS. 8A to 8E;
FIG. 12 is block diagram illustrating an audio device in an electronic device according to an embodiment of the disclosure;
FIG. 13 is block diagram illustrating an audio device in an electronic device according to an embodiment of the disclosure;
FIG. 14 is a waveform diagram illustrating electrical signals S₁ to S₈ flowing through the respective lines of the audio device in FIG. 13; and
FIG. 15 is a plan view illustrating an electronic device according to an embodiment of the disclosure.

In connection with the description of the drawings, the same or similar reference numerals may be used to denote the same or similar elements.

### [Mode for Carrying out the Invention]

Hereinafter, embodiments of the disclosure are described in detail with reference to the drawings so that those skilled in the art to which the disclosure pertains may easily practice the disclosure. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

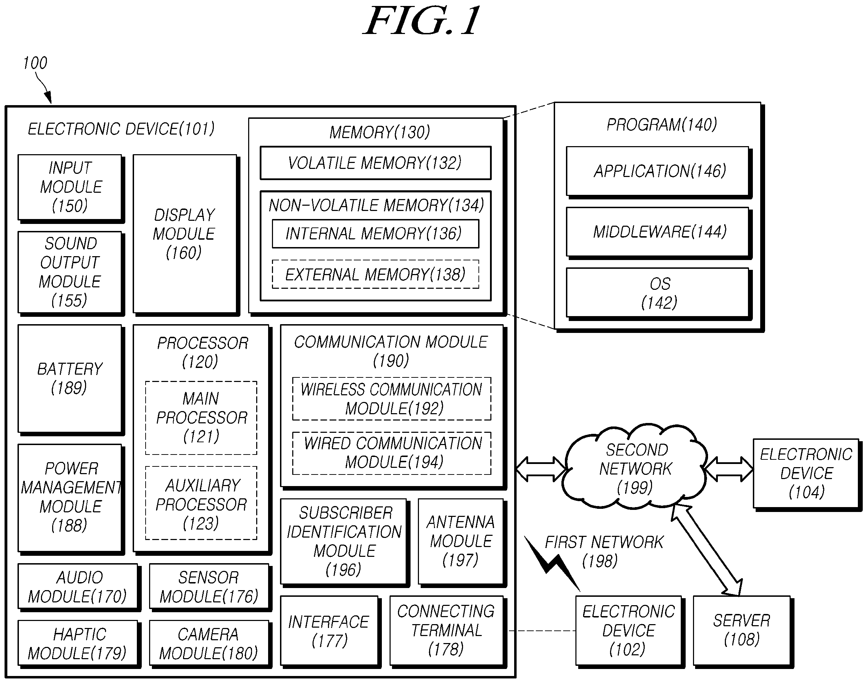

FIG. 1 is a block diagram illustrating an electronic device 101 in a network environment 100 according to various embodiments. Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102 or 104, or the server 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., a smart home, a smart city, a smart car, or healthcare) based on 5G communication technology or IoT-related technology.

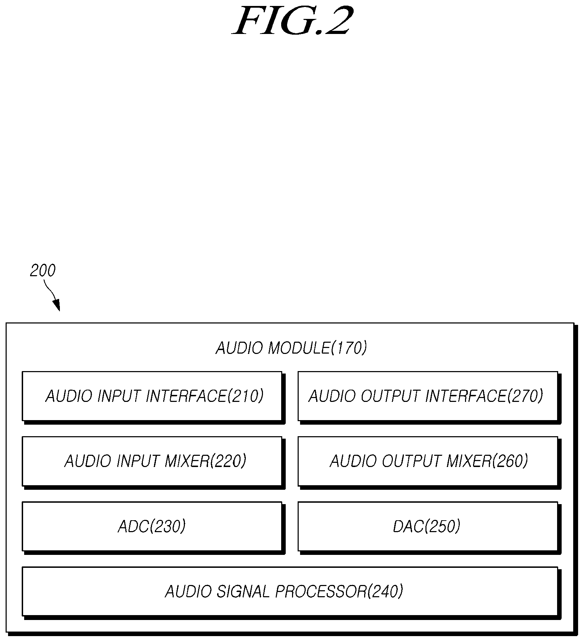

FIG. 2 is a block diagram 200 illustrating the audio module 170 according to various embodiments. Referring to FIG. 2, the audio module 170 may include, for example, an audio input interface 210, an audio input mixer 220, an analog-to-digital converter (ADC) 230, an audio signal processor 240, a digital-to-analog converter (DAC) 250, an audio output mixer 260, or an audio output interface 270.

The audio input interface 210 may receive an audio signal corresponding to a sound obtained from the outside of the electronic device 101 via a microphone (e.g., a dynamic microphone, a condenser microphone, or a piezo microphone) that is configured as part of the input module 150 or separately from the electronic device 101. For example, if an audio signal is obtained from the external electronic device 102 (e.g., a headset or a microphone), the audio input interface 210 may be connected with the external electronic device 102 directly via the connecting terminal 178, or wirelessly (e.g., Bluetooth^{™} communication) via the wireless communication module 192 to receive the audio signal. According to an embodiment, the audio input interface 210 may receive a control signal (e.g., a volume adjustment signal received via an input button) related to the audio signal obtained from the external electronic device 102. The audio input interface 210 may include a plurality of audio input channels and may receive a different audio signal via a corresponding one of the plurality of audio input channels, respectively. According to an embodiment, additionally or alternatively, the audio input interface 210 may receive an audio signal from another component (e.g., the processor 120 or the memory 130) of the electronic device 101.

The audio input mixer 220 may synthesize a plurality of inputted audio signals into at least one audio signal. For example, according to an embodiment, the audio input mixer 220 may synthesize a plurality of analog audio signals inputted via the audio input interface 210 into at least one analog audio signal.

The ADC 230 may convert an analog audio signal into a digital audio signal. For example, according to an embodiment, the ADC 230 may convert an analog audio signal received via the audio input interface 210 or, additionally or alternatively, an analog audio signal synthesized via the audio input mixer 220 into a digital audio signal.

The audio signal processor 240 may perform various processing on a digital audio signal received via the ADC 230 or a digital audio signal received from another component of the electronic device 101. For example, according to an embodiment, the audio signal processor 240 may perform changing a sampling rate, applying one or more filters, interpolation processing, amplifying or attenuating a whole or partial frequency bandwidth, noise processing (e.g., attenuating noise or echoes), changing channels (e.g., switching between mono and stereo), mixing, or extracting a specified signal for one or more digital audio signals. According to an embodiment, one or more functions of the audio signal processor 240 may be implemented in the form of an equalizer.

The DAC 250 may convert a digital audio signal into an analog audio signal. For example, according to an embodiment, the DAC 250 may convert a digital audio signal processed by the audio signal processor 240 or a digital audio signal obtained from another component (e.g., the processor(120) or the memory(130)) of the electronic device 101 into an analog audio signal.

The audio output mixer 260 may synthesize a plurality of audio signals, which are to be outputted, into at least one audio signal. For example, according to an embodiment, the audio output mixer 260 may synthesize an analog audio signal converted by the DAC 250 and another analog audio signal (e.g., an analog audio signal received via the audio input interface 210) into at least one analog audio signal.

The audio output interface 270 may output an analog audio signal converted by the DAC 250 or, additionally or alternatively, an analog audio signal synthesized by the audio output mixer 260 to the outside of the electronic device 101 via the sound output module 155. The sound output module 155 may include, for example, a speaker, such as a dynamic driver or a balanced armature driver, or a receiver. According to an embodiment, the sound output module 155 may include a plurality of speakers. In such a case, the audio output interface 270 may output audio signals having a plurality of different channels (e.g., stereo channels or 5.1 channels) via at least some of the plurality of speakers. According to an embodiment, the audio output interface 270 may be connected with the external electronic device 102 (e.g., an external speaker or a headset) directly via the connecting terminal 178 or wirelessly via the wireless communication module 192 to output an audio signal.

According to an embodiment, the audio module 170 may generate, without separately including the audio input mixer 220 or the audio output mixer 260, at least one digital audio signal by synthesizing a plurality of digital audio signals using at least one function of the audio signal processor 240.

According to an embodiment, the audio module 170 may include an audio amplifier (not shown) (e.g., a speaker amplifying circuit) that is capable of amplifying an analog audio signal inputted via the audio input interface 210 or an audio signal that is to be outputted via the audio output interface 270. According to an embodiment, the audio amplifier may be configured as a module separate from the audio module 170.

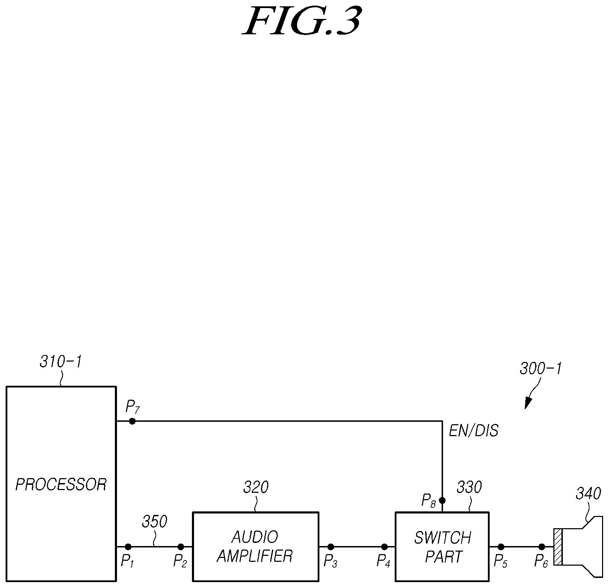

FIG. 3 is a block diagram illustrating an audio device 300-1 (e.g., the audio module 170 of FIG. 2) in an electronic device (e.g., the electronic device 101 of FIG. 1) according to an embodiment.

Referring to FIG. 3, the audio device 300-1 may include a processor 310-1, an audio amplifier 320, a switch part 330, or a sound output 340 (e.g., the sound output module 155 of FIG. 1).

The processor 310-1 may not be provided as a substantially independent component (e.g., the audio signal processor 240 of FIG. 2). The function of the processor 310-1 may be performed by, e.g., a main processor (e.g., the main processor 121 of FIG. 1) or an auxiliary processor (e.g., the auxiliary processor 123 of FIG. 1) instead. The processor 310-1 may be configured to perform various processing on a digital audio signal and output the same. The processor 310-1 may process a digital audio signal and output the same to the interface 350. The interface 350 may include, e.g., a digital interface. However, it is not limited thereto. The digital audio signal may be, e.g., a digital signal obtained by converting an audio signal input to an input interface (e.g., the audio input interface 210 of FIG. 2) by an ADC (e.g., the ADC 230 of FIG. 2). The audio signal input to the audio input interface 210 may be mixed with another audio signal in a mixer (e.g., the audio input mixer 220 of FIG. 2) before being input to the ADC 230. The digital interface 350 may be, e.g., an interface supporting a serial peripheral interface (SPI), an inter integrated circuit (I2C), or an integrated interchip sound (I2S).

The audio amplifier 320 may be electrically connected to the processor 310-1. The audio amplifier 320 may be electrically connected to the processor 310-1 through the digital interface 350. The audio amplifier 320 may amplify and output an audio signal output from the processor 310-1 and transferred through the digital interface 350. For example, the audio amplifier 320 may convert the amplified digital audio signal into an analog audio signal and output the analog audio signal.

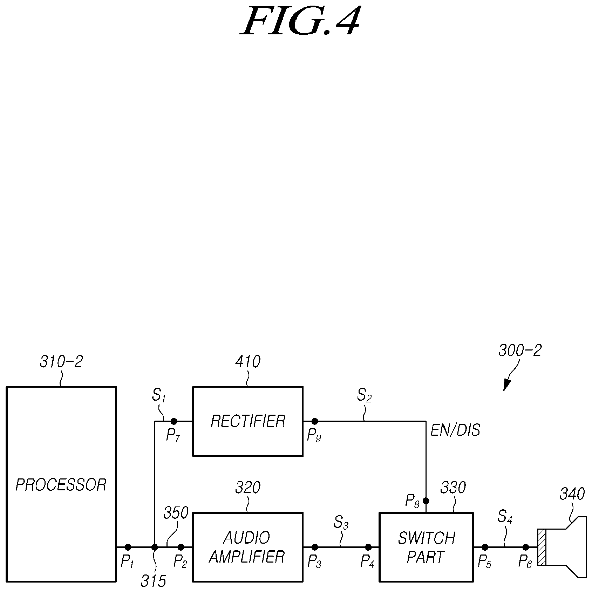

The switch part 330 may open, disconnect, or turn off or close, connect, or turn on the path a path electrically connecting the audio amplifier 320 and the sound output 340. The switch part 330 may perform a switching operation by a switching control signal (enable (EN) or disable (DIS)) provided from the outside. The switching control signal may be provided, e.g., by the processor 310-1 by one of an operation by software or an operation by hardware. For example, the operation by the software may output the switching control signal considering a requirement such as presence or absence of a digital audio signal to be output to the digital interface 350 by the processor 310-1. For example, if there is a digital audio signal to be output to the digital interface 350, the processor 310-1 may output a switching control signal (enable (EN)) for shorting the switch part 330 so that the audio amplifier 320 and the sound output 340 are electrically connected to each other. For example, if there is no digital audio signal to be output to the digital interface 350, the processor 310-1 may output a switching control signal (disable (DIS)) for opening the switch part 330 so that the audio amplifier 320 and the sound output 340 are electrically cut off. For example, the operation by the hardware may output the switching control signal through a rectifier (e.g., the rectifier 410 of FIG. 4) provided in the processor 310-1 considering a requirement such as presence or absence of a digital audio signal to be output to the digital interface 350 by the processor 310-1. For example, if there is a digital audio signal to be output to the digital interface 350, the rectifier 410 may output a switching control signal (enable (EN)) for shorting the switch part 330 so that the audio amplifier 320 and the sound output 340 are electrically connected. For example, if there is no digital audio signal to be output to the digital interface 350, the rectifier 410 may output a switching control signal (disable (DIS)) for opening the switch part 330 so that the audio amplifier 320 and the sound output 340 are electrically cut off.

The switch part 330 may be configured using, e.g., a metal oxide semiconductor field effect transistor (MOSFET). However, the disclosure is not limited thereto, and the switch part 330 may be configured by various types of switching elements.

The sound output 340 may output the amplified audio signal transferred from the audio amplifier 320 through the switch part 330 as a sound signal that the user may hear. The sound output 340 may include an output interface (e.g., the audio output interface 270 of FIG. 2). The sound output 340 may include at least one of a DAC (e.g., the DAC 250 of FIG. 2) or a mixer (e.g., the audio input mixer 220 of FIG. 2). The amplified audio signal may be converted into an analog audio signal by, e.g., the DAC 250 and then output through the audio output interface 270. The converted analog signal may be mixed with another analog audio signal in the audio output mixer 260 before being output through the audio output interface 270. The sound output 340 may share a speaker or a receiver included in the sound output module 155 of the electronic device 101. The speaker may be positioned at, e.g., an upper end or a lower end of the electronic device (e.g., the electronic device 101 of FIG. 1). The receiver may be positioned at, e.g., an upper end or a lower end of the electronic device 101. The sound output 340 may share a USB port or a 3.5 mm terminal included in a connecting terminal (e.g., the connecting terminal 178 of FIG. 1) of the electronic device 101. For example, a cable electrically connecting a sound output device (e.g., an earphone, a headphone, a speaker, or the like) may be inserted into the connecting terminal 178.

According to an embodiment, the output terminal P₁ provided in the processor 310-1 may be electrically connected to the input terminal P₂ provided in the audio amplifier 320 by the digital interface 350. The output terminal P₇ provided in the processor 310-1 may be electrically connected to the input terminal P₈ provided in the switch part 330.

According to an embodiment, the input terminal P₂ provided in the audio amplifier 320 may be electrically connected to the output terminal P₁ provided in the processor 310-1. The output terminal P₃ provided in the audio amplifier 320 may be electrically connected to the input terminal P₄ provided in the switch part 330.

According to an embodiment, the input terminal P₄ provided in the switch part 330 may be electrically connected to the output terminal P₃ provided in the audio amplifier 320. The input terminal P₈ provided in the switch part 330 may be electrically connected to the output terminal P₇ provided in the processor 310-1. The output terminal P₅ provided in the switch part 330 may be electrically connected to the input terminal P₆ provided in the sound output 340.

According to an embodiment, the processor 310-1 may detect the presence or absence of an audio signal. For example, the processor 310-1 may detect whether there is an audio signal to be output to the digital interface 350 electrically connecting the audio amplifier 320. When there is an audio signal to be output to the digital interface 350, the processor 310-1 may output an enable (EN) signal to the output terminal P₇. When there is no audio signal to be output to the digital interface 350, the processor 310-1 may output a disable (DIS) signal to the output terminal P₇. The switching control signal, which is one of the enable (EN) signal or the disable (DIS) signal, may be transferred to the input terminal P₈ of the switch part 330.

According to an embodiment, the switch part 330 may receive a switching control signal from the processor 310-1 through the input terminal P₈. The switching control signal may be, e.g., one of an enable (EN) signal or a disable (DIS) signal. If the switching control signal is an enable (EN) signal, the switch part 330 may be closed, connected, or turned on. The shorting of the switch part 330 allows a path for transferring the amplified audio signal output from the audio amplifier 320 to the sound output 340 to be formed. If the switching control signal is a disable (DIS) signal, the switch part 330 may be opened, disconnected, or turned off. The opening of the switch part 330 cuts off the path for transferring the amplified audio signal output from the audio amplifier 320 to the sound output 340.

According to an embodiment, the processor 310-1 may control the switch part 330 in a timing control manner. For example, if an audio signal is generated, the processor 310-1 may output a signal (e.g., an enable (EN) signal or a disable (DIS) signal) for controlling the switch part 330 after a predetermined delay from a time point at which the audio signal is generated. The predetermined delay may be a time interval that is difficult for a person to feel. The predetermined delay may be, e.g., a time interval of several milliseconds (ms) to tens of milliseconds (ms).

FIG. 4 is a block diagram illustrating an audio device 300-2 in an electronic device (e.g., the electronic device 101 of FIG. 1) according to an embodiment of the disclosure.

Unlike the audio device 300-1 of FIG. 3, the audio device 300-2 of FIG. 4 includes a rectifier 410 as a separate component. The other components may be the same as those of the audio device 300-1 of FIG. 3.

Referring to FIG. 4, the audio device 300-2 may include a processor 310-2, an audio amplifier 320, a switch part 330, a sound output 340, or a rectifier 410. The processor 310-1 may output the switching control signal through a rectifier (e.g., the rectifier 410 of FIG. 4) provided in the processor 310-1 considering a requirement such as presence or absence of a digital audio signal to be output to the digital interface 350.

The rectifier 410 may be configured as, e.g., a circuit of a low pass filter (LPF). However, the disclosure is not limited thereto, and various types of filter circuits may be included. The rectifier 410 may convert a pulsed signal into a signal maintaining a constant voltage. The rectifier 410 may convert an AC-type voltage into a DC-type voltage. The converted signal may maintain a peak signal. The signal in which the peak signal is maintained may be defined as a high level signal. The high level signal may be an enable (EN) signal for controlling to connect the switch part 330.

According to an embodiment, any point 315 on the digital interface 350 may be electrically connected to an input terminal P₇ provided in the rectifier 410. The output terminal P₉ provided in the rectifier 410 may be electrically connected to the input terminal P₈ provided in the switch part 330.

If there is an audio signal to be output from the processor 310-2 toward the digital interface 350, the rectifier 410 may output an enable (EN) signal to the output terminal P₉. If there is no audio signal to be output from the processor 310-2 toward the digital interface 350, the rectifier 310-1 may output a disable (DIS) signal to the output terminal P₉. The switching control signal, which is one of the enable (EN) signal or the disable (DIS) signal, may be transferred to the input terminal P₈ of the switch part 330.

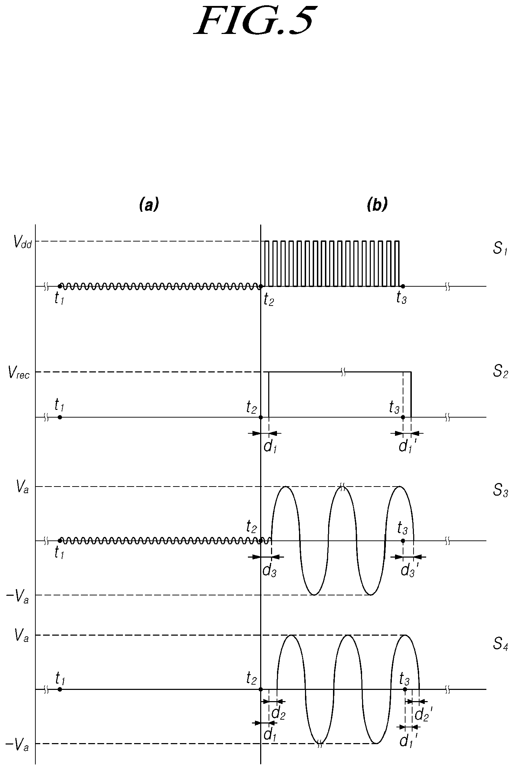

According to an embodiment, an electrical signal may be generated in each component of the audio device 300. The electrical signal may include an audio signal. The audio signal may flow on an electrical line connected between components. The audio signal flowing from the processor 310-2 toward the audio amplifier 320 may be referred to as S₁. The audio signal flowing from an arbitrary point 315 on the digital interface 350 to the input terminal P₇ of the rectifier 410 may be referred to as S₁. The audio signal flowing from the output terminal P₉ of the rectifier 410 to the input terminal P₈ of the switch part 330 may be referred to as S₂. The audio signal flowing from the output terminal P₃ of the audio amplifier 320 to the input terminal P₄ of the switch part 330 may be referred to as S₃. The audio signal flowing from the output terminal P₅ of the switch part 330 to the input terminal P₆ of the sound output 340 may be referred to as S₄. A waveform diagram of the audio signals S₁, S₂, S₃, and S₄ is described with reference to FIG. 5.

FIG. 5 is a waveform diagram illustrating electrical signals S₁, S₂, S₃, and S₄ flowing through the respective lines of the audio device (e.g., the audio device 300-2 of FIG. 4) in FIG. 4.

Referring to FIG. 5, section (a) may be a section in which there is no audio signal output to a digital interface (e.g., the digital interface 350 of FIG. 4) by a processor (e.g., the processor 310-2 of FIG. 4) of the audio device 300-2. Section (a) may be, e.g., a section in which the audio device 300-2 operates in an idle state. If there is no input audio signal, the audio device 300-2 may operate in the idle state.

Section (b) may be a section in which there is an audio signal output to the digital interface 350 by the processor 310-2. Section (b) may be, e.g., a section in which the audio device 300-2 operates in an active state. If there is an input audio signal, the audio device 300-2 may operate in the active state.

The signal S₁ may be an electrical signal flowing from the output terminal P₁ of the processor 310-2 toward the input terminal P₂ of the audio amplifier (e.g., the audio amplifier 320 of FIG. 3). The signal S₁ may be an electrical signal that the rectifier (e.g., the rectifier 410 of FIG. 4) may obtain at any point 315 on the digital interface 350 that electrically connects the output terminal P₁ of the processor 310-2 and the input terminal P₂ of the audio amplifier 320.

In the signal S₁, e.g., a fine electrical signal may be present in section (a), and a digital audio signal may be present in section (b). The fine electrical signal that may be present in section (a) (e.g., time points t₁ to t₂) may correspond to audible noise. The audible noise signal may be generated by, e.g., an electrical signal generated by an element or component disposed around the audio device 300-2 and/or an electrical signal flowing through a conductive line passing around the audio device 300-2. A pulsed electrical signal that may be present in section (b) (e.g., time points t₂ to t₃) may correspond to a digital audio signal. For example, the digital audio signal may be output to the digital interface 350 by the processor 310-2 through the output terminal P₁. The digital audio signal may have, e.g., a pulse form in which +V_{dd} is an upper level and 0 is a lower level.

The signal S₂ may be an electrical signal in which the signal S₁ passes through the rectifier 410 (e.g., the rectifier 410 of FIG. 4) and is output to the output terminal P₉ of the rectifier 410.

The signal S₂ may be an audio signal output from the output terminal P₉ of the rectifier 410 to the input terminal P₈ of the switch part (e.g., the switch part 330 of FIG. 3). If a fine electrical signal passes through the rectifier 410 in section (a), an audio signal having a voltage of 0V may be generated. The audio signal may correspond to a disable (DIS) signal for controlling to open the switch part 330. If the pulsed signal S₁ having the upper limit level +V_{dd} and the lower limit level 0 passes through the rectifier 410 in section (b), the signal S₂ may be converted into a digital audio signal having a constant voltage. The constant voltage may correspond to V_{rec}. If V_{rec} is a digital audio signal of a predetermined voltage level or more, V_{rec} may correspond to an enable (EN) signal for controlling to short the switch part 330.

The signal S₂ may be, e.g., a digital audio signal having a voltage level of V_{rec} from a time point t₂+d₁ to a time point t₃+d₁'. d₁ or d₁' may correspond to a delay time. The delay time may correspond to a time required for the signal S₁ to be processed as the signal S₂ by the rectifier 410. The delay time may be a delay time. d₁ and d₁' may or may not be the same. d₁ and d₁' may correspond to substantially small values close to zero. Therefore, the user may not feel the delay time.

The signal S₃ may correspond to an audio signal flowing from the output terminal P₃ of the audio amplifier 320 to the input terminal P₄ of the switch part 330. The digital audio signal of signal S₁ may be amplified by an audio signal processor (e.g., the audio signal processor 240 of FIG. 2) provided in the audio amplifier 320. The signal S₁ input to the audio amplifier 320 may be converted into an analog audio signal in a DAC (e.g., the DAC 250 of FIG. 2) of the audio amplifier 320. d₃ or d₃' may be defined as a delay time required for the signal S₁ to be amplified by the audio amplifier 320 to the signal S₃. d₃ may be a value having a relationship of d₁≤d₃. d₃' may have a relationship of d₁'≤d₃'.

Fine electrical signals that may be present in section (a) (e.g., from time point t₁ to t₂+d₃) may correspond to audible noise. The audible noise signal may be generated by, e.g., an electrical signal generated by an element or component disposed around the audio device 300-2 and/or an electrical signal flowing through a conductive line passing around the audio device 300-2. A sinusoidal electrical signal that may be present in section (b) (e.g., from time point t₂+d₃ to time point t₃+d₃') may correspond to an audio signal. The audio signal may include, e.g., an analog signal output through a receiver included in the electronic device 101 or a 3.5 mm earphone connected to the electronic device 101. The audio signal may include, e.g., a digital signal output in a D-class form. For example, the audio signal may be input to the switch part 330 through the output terminal P₃ of the audio amplifier 320. The audio signal may have, e.g., a sinusoidal wave having +Vₐ as an upper limit level and -Vₐ as a lower limit level. For convenience of description, the waveform of the signal S₃ illustrated is illustrated as a sinusoidal wave, but is not limited thereto, and may have various amplitudes, periods, frequencies, and waveforms according to the type and kind of the audio signal.

The signal S₄ may correspond to an audio signal flowing from the output terminal P₅ of the switch part 330 to the input terminal P₆ of the sound output 340. The audio signal may be output as a sound signal that is an audible signal that the user may hear through the sound output 340.

In section (a), a disable (DIS) signal for controlling to open the switch part 330 may flow from the output terminal P₉ of the rectifier 410 to the input terminal P₈ of the switch part 330 . In response thereto, the switch part 330 may be opened. Therefore, audible noise (e.g., audible noise generated due to a fine electrical signal from the time point t₁ to the time point t₂+d₃ of S₃) generated in the section (a) may be cut off.

In section (b), an enable (EN) signal for controlling to short the switch part 330 may flow from the output terminal P₉ of the rectifier 410 to the input terminal P₈ of the switch part 330 . In response thereto, the switch part 330 may be shorted. Accordingly, the analog audio signal converted by the audio amplifier 320 may be output as a sound signal through the sound output 340.

From t₂+d₁+d₂ to t₃+d₁'+d₂' in section (b), an audio signal having +Vₐ as an upper limit level and -Vₐ as a lower limit level may be generated. The audio signal may include an analog audio signal or a digital audio signal. The audio signal may include, e.g., an analog signal output through a receiver included in the electronic device 101 or a 3.5 mm earphone connected to the electronic device 101. The audio signal may include, e.g., a digital signal output in a D-class form. The audio signal may have a sinusoidal wave shape. However, the disclosure is not limited thereto, and the audio signal may have various amplitudes, periods, frequencies, and waveforms according to the type and kind of the audio signal. d₂ or d₂' may correspond to a predetermined delay time after the switch part 330 is connected by the enable (EN) signal. The delay time may be a guard time. By setting the guard time, it is possible to prevent pop noise from occurring in the sound output 340. d₂ and d₂' may or may not be the same. d₂ and d₂' may correspond to small values substantially close to zero. Therefore, the user may not feel the delay time as much as d₁, d₁', d₂, and d₂'. d₂ may be a value having a relationship of d₁≤d₃≤d₁+d₂. d₂' may have a relationship of d₁'≤d₃'≤d₁'+d₂'.

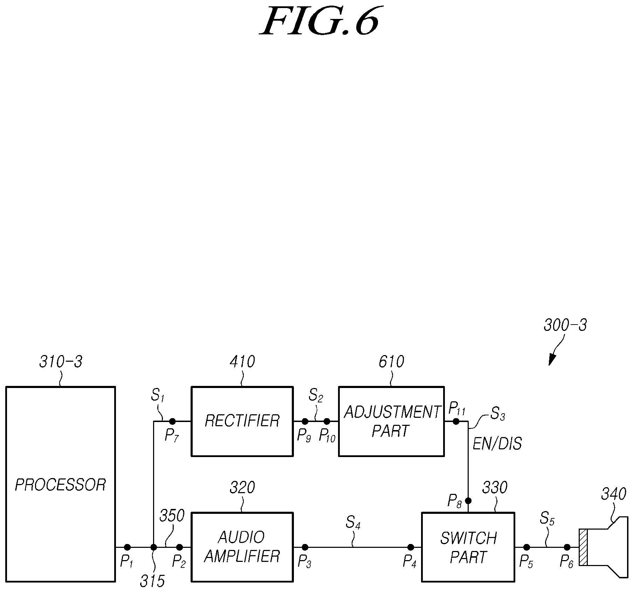

FIG. 6 is a block diagram illustrating an audio device 300-3 in an electronic device (e.g., the electronic device 101 of FIG. 1) according to an embodiment of the disclosure.

Unlike the audio device 300-2 of FIG. 4, the audio device 300-3 of FIG. 6 includes an adjustment part 610 as a separate component. The other components may be the same as those of the audio device 300-2 of FIG. 4.

Referring to FIG. 6, the audio device 300-3 may include a processor 310-2, an audio amplifier 320, a switch part 330, a sound output 340, a rectifier 410, or an adjustment part 610. The size of the audio signal may be adjusted through the adjustment part 610 considering the requirement of the audio signal to be output by the rectifier 410.

The adjustment part 610 may boost or drop, e.g., the voltage of the audio signal converted by the rectifier 410. The audio signal converted by the rectifier 410 may not have a voltage level sufficient to short or open the switch part 330. The adjustment part 610 may output the boosted or dropped audio signal from the output terminal P₁₁ of the adjustment part 610 to the input terminal P₈ of the switch part 330. The adjustment part 610 may include a low dropout (LDO) regulator, but is not limited thereto and may include various types of regulators.

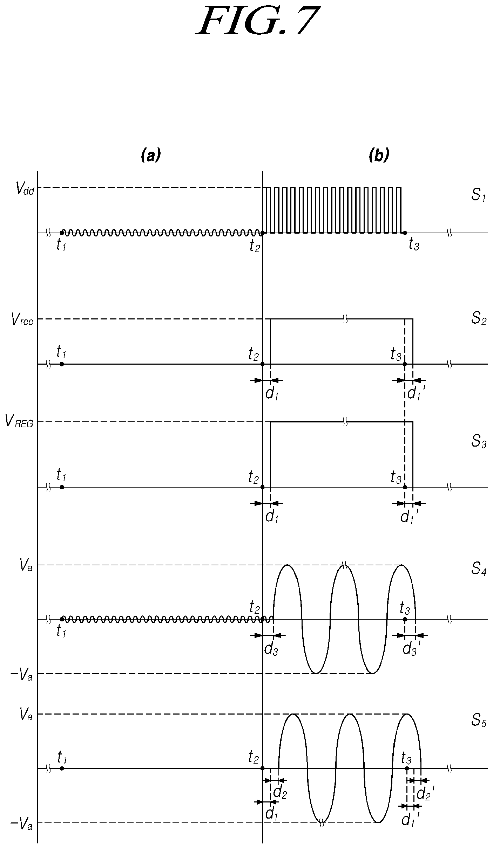

According to an embodiment, an electrical signal may be generated in each component of the audio device 300-3. The electrical signal may include an audio signal. The audio signal may flow on an electrical line connected between components. The audio signal flowing from the processor 310-2 toward the audio amplifier 320 may be referred to as S₁. The audio signal flowing from an arbitrary point 315 on the digital interface 350 to the input terminal P₇ of the rectifier 410 may be referred to as S₁. The audio signal flowing from the output terminal P₉ of the rectifier 410 to the input terminal P₁₀ of the adjustment part 610 may be referred to as S₂. The audio signal flowing from the output terminal P₁₁ of the adjustment part 610 to the input terminal P₈ of the switch part 330 may be referred to as S₃. The audio signal flowing from the output terminal P₃ of the audio amplifier 320 to the input terminal P₄ of the switch part 330 may be referred to as S₄. The audio signal flowing from the output terminal P₅ of the switch part 330 to the input terminal P₆ of the sound output 340 may be referred to as S₅. The waveform diagram of the audio signals S₁, S₂, S₃, S₄, and S₅ is described with reference to FIG. 7.

FIG. 7 is a waveform diagram illustrating electrical signals S₁, S₂, S₃, S₄, and S₅ flowing through the respective lines of the audio device 300-3 in FIG. 6.

In FIG. 7, the waveforms of signals other than the signal (e.g., S₃ of FIG. 6) passing through the adjustment part are the same as those of FIG. 5, and thus the description focuses primarily on the differences.

Referring to FIG. 7, signals S₁, S₄, and S₅ respectively correspond to signals S₁, S₃, and S₄ of FIG. 5.

According to an embodiment, section (a) may be a section in which there is no audio signal output to a digital interface (e.g., the digital interface 350 of FIG. 6) by a processor (e.g., the processor 310-2 of FIG. 6) of the audio device 300-3. Section (a) may be, e.g., a section in which the audio device 300-3 operates in an idle state. If there is no input audio signal, the audio device 300-3 may operate in the idle state.

Section (b) may be a section in which there is an audio signal output to the digital interface 350 by the processor 310-2. Section (b) may be, e.g., a section in which the audio device 300-3 operates in an active state. If there is an input audio signal, the audio device 300-3 may operate in the active state.

The signal S₂ may be an audio signal in which the signal S₁ passes through the rectifier 410 (e.g., the rectifier 410 of FIG. 4) and is output to the output terminal P₉ of the rectifier 410.

The signal S₂ may be an audio signal output from the output terminal P₉ of the rectifier 410 to the input terminal P₁₀ of the adjustment part (e.g., the adjustment part 610 of FIG. 6). If a fine electrical signal passes through the rectifier 410 in section (a), an audio signal having a voltage of 0V may be output. The audio signal may correspond to a disable (DIS) signal for controlling to open the switch part 330. If the pulsed signal S₁ having the upper limit level +V_{dd} and the lower limit level 0 passes through the rectifier 410 in section (b), the signal S₂ may be converted into a digital audio signal having a constant voltage. The constant voltage may correspond to V_{rec}. If V_{rec} is a digital audio signal of a predetermined voltage level or more, V_{rec} may correspond to an enable (EN) signal for controlling to short the switch part 330. The audio signal converted by the rectifier 410 may not have a voltage level sufficient to short or open the switch part 330.

The signal S₃ may be an audio signal flowing from the output terminal P₁₁ of the adjustment part 610 to the input terminal P₈ of the switch part 330. The voltage of the audio signal passing through the adjustment part 610 may be boosted or dropped. If the audio signal passes through the controller in section (a), an audio signal having a voltage of 0V may be generated. The audio signal may correspond to a disable (DIS) signal for controlling to open the switch part 330. If the signal S₂ having the voltage level of V_{rec} passes through the regulator in section (b), the signal S₃ may be converted into an audio signal having a constant voltage. The constant voltage may correspond to V_{REG}. If V_{REG} is an audio signal having a sufficient voltage level to short the switch part 330, it may correspond to an enable (EN) signal for controlling to short the switch part 330. FIG. 7 illustrates a case of V_{rec}≤V_{REG}, but the disclosure is not limited thereto.

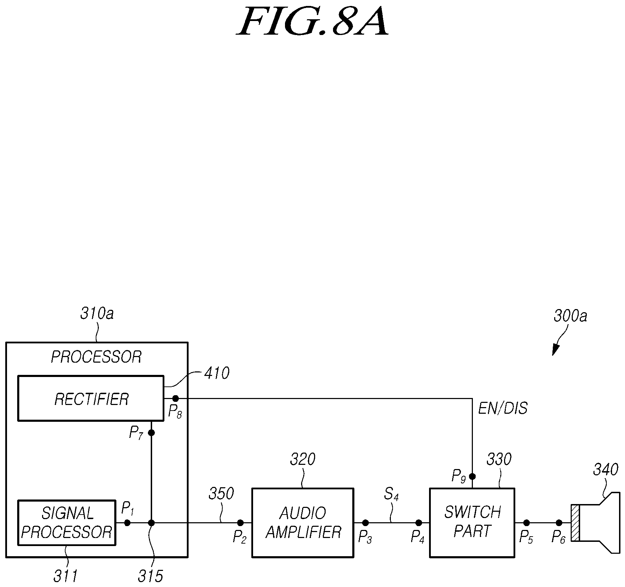

FIGS. 8A to 8E are layout views illustrating components included in an audio device 300a, 300b, 300c, 300d, or 300e in an electronic device (e.g., the electronic device 101 of FIG. 1) according to an embodiment of the disclosure.

Referring to FIG. 8A, an audio device 300a (e.g., the audio device 300-1 of FIG. 3) may include a processor 310a (e.g., the processor 310-1 of FIG. 3) having a rectifier 410 disposed therein to output a switching control signal in response to presence or absence of a digital audio signal. The processor 310a may include a signal processor 311 (e.g., the audio signal processor 240 of FIG. 2). The processor 310a including the rectifier 410 and/or the signal processor 311 may be configured as one integrated circuit. In one integrated circuit constituting the processor 310a, the input terminal P₇ of the rectifier 410 may be electrically connected to the output terminal P₁ of the signal processor 311. Due to the electrical connection, the digital audio signal output to the output terminal P₁ of the signal processor 311 may be transferred to the input terminal P₇ of the rectifier 410.

The signal processor 311 included in the processor 310a may perform various processing on the digital audio signal. The signal processor 311 may perform, e.g., sampling rate change, application of one or more filters, interpolation processing, amplification or attenuation of the whole or partial frequency band, noise processing (e.g., noise or echo attenuation), channel switch (e.g., mono-stereo switch), mixing, or designated signal extraction for one or more digital audio signals. One or more functions of the signal processor 311 may be implemented in the form of an equalizer.

The rectifier 410 included in the processor 310a may output a switching control signal output to the output terminal P₈ considering the digital audio signal input through the input terminal P₇. The signal processor 311 of the processor 310a may be electrically connected to the audio amplifier 320.

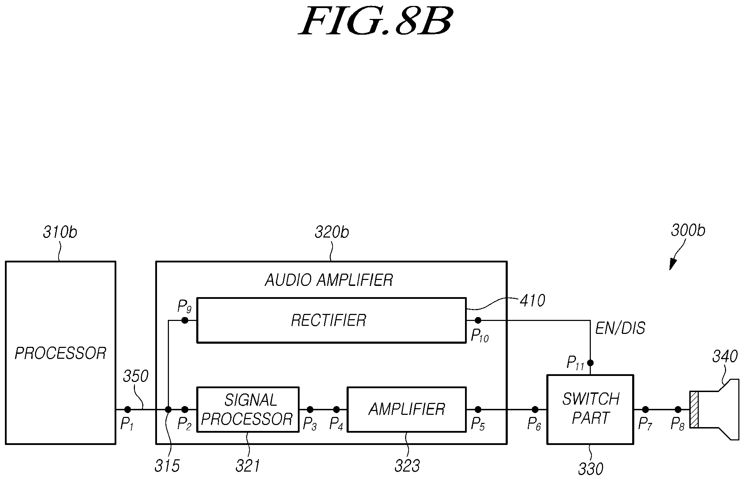

Referring to FIG. 8B, the audio device 300b may include a processor 310b, an audio amplifier 320b, a switch part 330, or a sound output 340. The audio amplifier 320b may include a signal processor 321, an amplifier 323, or a rectifier 410. The rectifier 410 and the audio amplifier 320b may be configured as one integrated circuit. The signal processor 321 may perform various processing on the digital audio signal. For example, the signal processor 321 may perform a sampling rate change, application of one or more filters, interpolation processing, noise processing (e.g., noise or echo attenuation), channel switch (e.g., mono-stereo switch), mixing, or designated signal extraction for one or more digital audio signals. According to an embodiment, one or more functions of the signal processor 321 may be implemented in the form of an equalizer. The amplifier 323 may amplify or attenuate the entire or partial frequency band of the audio signal input through the signal processor 321.

The processor 310b may be electrically connected to the signal processor 321 of the audio amplifier 320b. The signal processor 321 may be electrically connected to the amplifier 323. The amplifier 323 may be electrically connected to the switch part 330.

Any point 315 on the audio interface 350 between the processor 310b and the audio amplifier 320b may be electrically connected to the rectifier 410. The rectifier 410 may be electrically connected to the switch part 330.

If there is a digital audio signal, the digital audio signal may flow from the output terminal P₁ of the processor 310b to the input terminal P₂ of the signal processor 321. The digital audio signal input to the signal processor 321 may be transferred to the input terminal P₇ of the rectifier 410.

The digital audio signal output from the output terminal P₃ of the signal processor 321 may be transferred to the input terminal P₄ of the amplifier 323. The digital audio signal may pass through the amplifier 323 to amplify or attenuate the entire or partial frequency band. The digital audio signal output from the output terminal P₅ of the amplifier 323 may be transferred to the input terminal P₆ of the switch part 330.

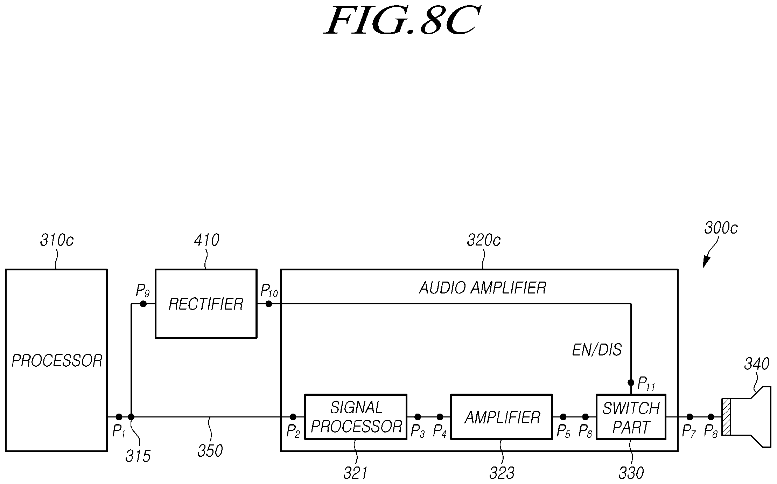

Referring to FIG. 8C, the audio device 300c may be an application example of the audio device 300-2 of FIG. 4. The audio device 300c may include a processor 310c, a rectifier 410, an audio amplifier 320c, or a sound output 340. The audio amplifier 320c may include a signal processor 321, an amplifier 323, or a switch part 330. The switch part 330 and the audio amplifier 320c may be configured as one integrated circuit.

The signal processor 321 provided in the audio amplifier 320c may be electrically connected to the amplifier 323. The amplifier 323 provided in the audio amplifier 320c may be electrically connected to the switch part 330.

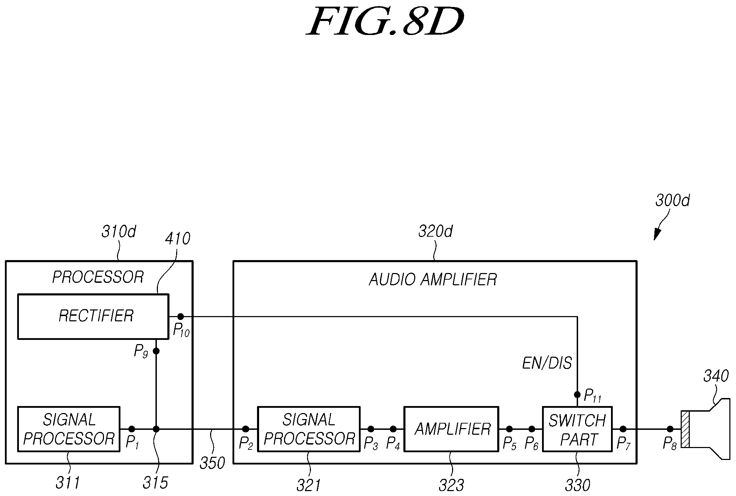

Referring to FIG. 8D, the audio device 300d may be an application example of the audio device 300-1 of FIG. 3. The audio device 300d may include a processor 310d, an audio amplifier 320d, or a sound output 340. The processor 310d may include a first signal processor 311 or a rectifier 410. The processor 310d may correspond to the processor 310a of FIG. 8A. The first signal processor 311 may correspond to the signal processor 311 of FIG. 8A. The audio amplifier 320d may include a second signal processor 321, an amplifier 323, or a switch part 330. The audio amplifier 320d may correspond to the audio amplifier 320c of FIG. 8C. The rectifier 410 and the processor 310d may be configured as one integrated circuit. The switch part 330 and the audio amplifier 320d may be configured as one integrated circuit.

The first signal processor 311 of the processor 310d may be electrically connected to the second signal processor 321 of the audio amplifier 320d.

If there is a digital audio signal, the digital audio signal output from the output terminal P₁ of the first signal processor 311 may be input to the input terminal P₂ of the second signal processor 321.

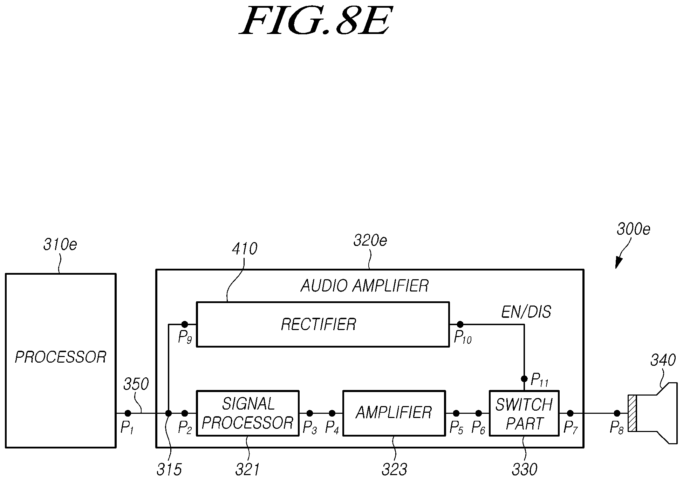

Referring to FIG. 8E, the audio device 300e may be an application example of the audio device 300-2 of FIG. 4. The audio device 300e may include a processor 310e, an audio amplifier 320e, or a sound output 340. The audio amplifier 320e may include a signal processor 321, an amplifier 323, a switch part 330, or a rectifier 410. The audio amplifier 320e, the rectifier 410, or the switch part 330 may be configured as one integrated circuit.

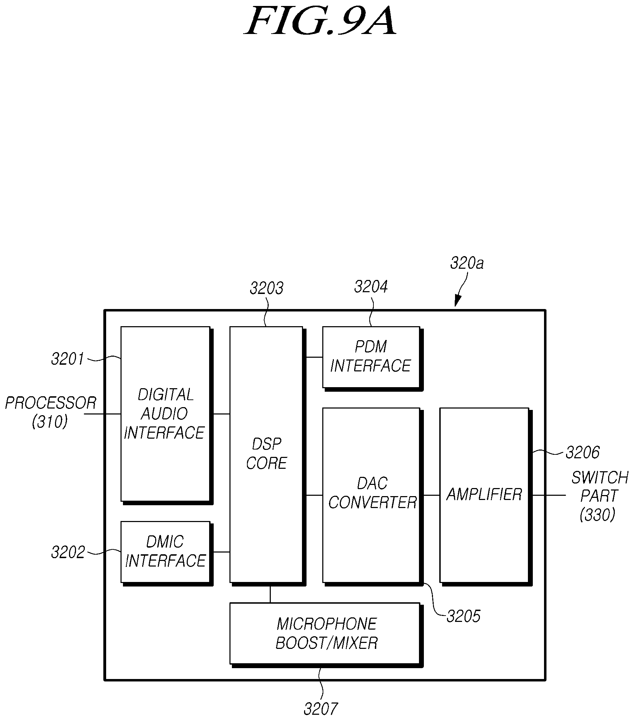

FIG. 9A is a block diagram illustrating an audio amplifier 320a included in the audio device 300a of FIG. 8A.

Referring to FIG. 9A, the audio amplifier 320a may include a digital audio interface 3201, a digital microphone (DMIC) interface 3202, a digital signal processing (DSP) core 3203, a pulse density modulation (PDM) interface 3204, a digital to analog (DAC) converter 3205, an amplifier 3206, or a microphone boost & mixer 3207. However, the disclosure is not limited thereto, and various components may be included.

According to an embodiment, the processor 310 and the audio amplifier 320a may be electrically connected. The audio amplifier 320a and the switch part 330 may be electrically connected to each other. The processor 310 and the digital audio interface 3201 may be electrically connected. The digital audio interface 3201 and the digital signal processing core 3203 may be electrically connected. The digital microphone interface 3202 and the digital signal processing core 3203 may be electrically connected to each other. The digital signal processing core 3203 and the PDM interface 3204 may be electrically connected to each other. The digital signal processing core 3203 and the DAC converter 3205 may be electrically connected to each other. The digital signal processing core 3203 and the microphone boost & mixer 3207 may be electrically connected. The DAC converter 3205 and the amplifier 3206 may be electrically connected to each other. The amplifier 3206 and the switch part 330 may be electrically connected to each other. However, the disclosure is not limited thereto, and various combinations of electrical connections between components constituting the audio amplifier 320a may be possible.

The digital audio interface 3201 may fully or partially correspond to the audio input interface 210 of FIG. 2. The digital audio interface 3201 may be connected to an external electronic device (e.g., the electronic device 102 of FIG. 1) directly via a connecting terminal (e.g., the connecting terminal 178 of FIG. 1) or wirelessly (e.g., Bluetooth communication) via a wireless communication module (e.g., the wireless communication module 192 of FIG. 1) to receive an audio signal. In an embodiment, the audio interface 3201 may receive a control signal (e.g., a volume adjustment signal received through an input button) related to the audio signal obtained from the external electronic device 102. The audio interface 3201 may include a plurality of audio input channels, and may receive different audio signals for each corresponding audio input channel among the plurality of audio input channels. According to an embodiment, additionally or alternatively, the audio interface 3201 may receive an audio signal from another component (e.g., the processor 310 or the memory) of the electronic device 101.

The digital microphone interface 3202 and the digital microphone may be connected, and sound converted by the digital microphone in a pulse code modulation (PCM) method may be received and transferred to the DSP core 3203.

The digital signal processing core 3203 may fully or partially correspond to the audio signal processor 240 of FIG. 2. The digital signal processing core 3203 may perform various processing on a digital audio signal or a digital audio signal received from another component of the electronic device 101. In an embodiment, the audio signal processor 240 may perform application of one or more filters, interpolation processing, amplification or attenuation of the whole or partial frequency band, noise processing (e.g., noise or echo attenuation), channel switch (e.g., mono-stereo switch), mixing, or designated signal extraction. According to an embodiment, one or more functions of the audio signal processor 3203 may be implemented in the form of an equalizer.

The PDM Interface 3204 may change a sampling ratio for one or more digital audio signals.

The DAC converter 3205 may fully or partially correspond to the DAC 250 of FIG. 2. The DAC converter 3205 may convert a digital audio signal into an analog audio signal. In an embodiment, the DAC converter 3205 may convert a digital audio signal processed by the audio signal processor 240 or a digital audio signal obtained from another component (e.g., the processor 310 or the memory) of the electronic device 101 into an analog audio signal.

The amplifier 3206 may correspond to the amplifier 323 of FIGS. 8A to 8E. The amplifier 3206 may amplify the analog signal converted by the DAC converter 3205. The amplifier 3206 may amplify the converted analog signal by a method of increasing the amplitude.

The microphone boost & mixer 3207 may fully or partially correspond to the audio input mixer 220 of FIG. 2 or the audio output mixer 260 of FIG. 2. The microphone boost & mixer 3207 may amplify the audio signal input through the microphone. The microphone boost & mixer 3207 may synthesize the plurality of input audio signals into at least one audio signal. In an embodiment, an analog-converted audio signal and another analog audio signal (e.g., an analog audio signal received through the audio input interface 210) may be synthesized into at least one analog audio signal.

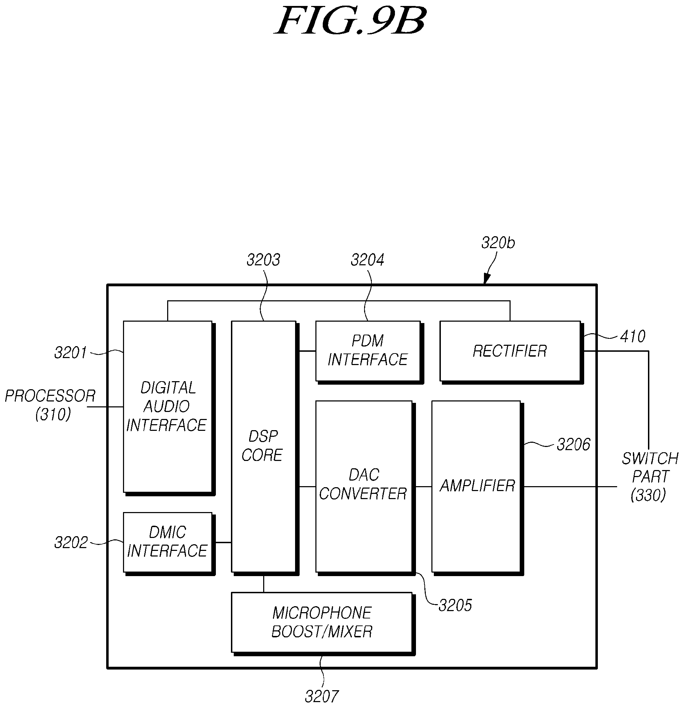

In FIGS. 9B to 9D, the plurality of components constituting the audio amplifier 320 and the connection relationship between the plurality of components are the same as those of FIG. 9A except for some part, and thus, the description focuses primarily on the differences.

FIG. 9B is a block diagram illustrating an audio amplifier 320b included in the audio device 300b of FIG. 8B.

Referring to FIG. 9B, the audio amplifier 320b may include a digital audio interface 3201, a digital microphone interface (DMIC) 3202, a digital signal processing core 3203 (DSP core), a pulse density modulation (PDM) interface 3204, a DAC converter 3205, an amplifier 3206, a microphone boost & mixer 3207, or a rectifier 410. The audio amplifier 320b and the rectifier 410 may be configured as one integrated circuit.

The digital audio interface 3201 and the rectifier 410 may be electrically connected to each other. The rectifier 410 and the switch part 330 may be electrically connected to each other.

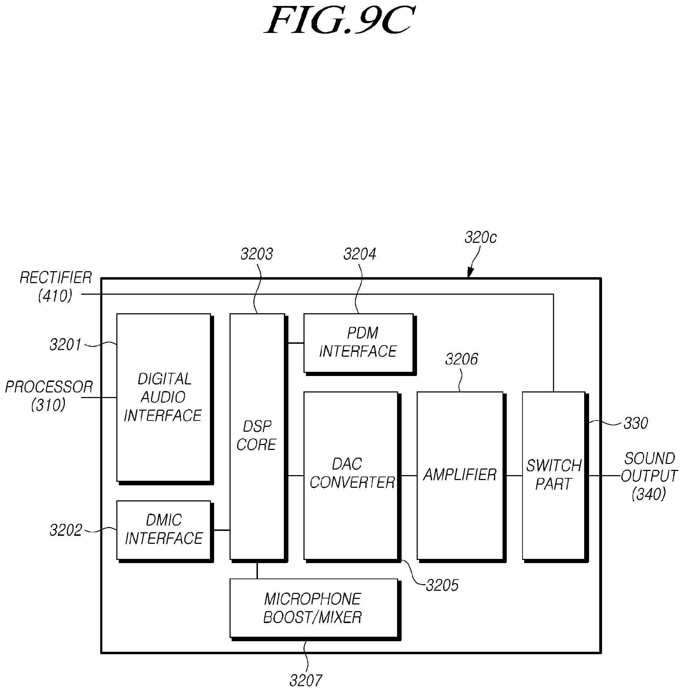

FIG. 9C is a block diagram illustrating an audio amplifier 320c (e.g., the audio amplifier 320c of FIG. 8C or the audio amplifier 320d of FIG. 8D) included in the audio device 300c or 300d of FIG. 8C or 8D.

Referring to FIG. 9C, the audio amplifier 320c may include a digital audio interface 3201, a digital microphone interface (DMIC) 3202, a digital signal processing core 3203 (DSP core), a pulse density modulation (PDM) interface 3204, a DAC converter 3205, an amplifier 3206, a microphone boost & mixer 3207, or a switch part 330. The audio amplifier 320c and the switch part 330 may be configured as one integrated circuit.

The amplifier 3206 and the switch part 330 may be electrically connected to each other. The switch part 330 and the sound output 340 may be electrically connected. The rectifier 410 and the switch part 330 may be electrically connected to each other.

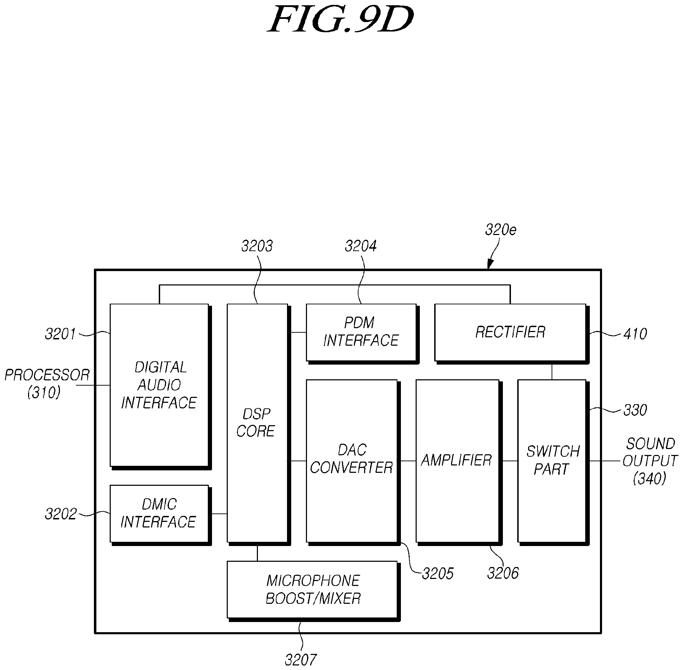

FIG. 9D is a block diagram illustrating an audio amplifier 320e included in the audio device 300e of FIG. 8E.

Referring to FIG. 9D, the audio amplifier 320e may include a digital audio interface 3201, a digital microphone interface (DMIC) 3202, a digital signal processing core 3203 (DSP core), a pulse density modulation (PDM) interface 3204, a DAC converter 3205, an amplifier 3206, a microphone boost & mixer 3207, a rectifier 410, or a switch part 330. The audio amplifier 320e, the rectifier 410, or the switch part 330 may be configured as one integrated circuit.

The digital audio interface 3201 and the rectifier 410 may be electrically connected to each other. The rectifier 410 and the switch part 330 may be electrically connected to each other.

In addition to those described with reference to FIGS. 9A to 9D, the audio amplifiers 320a, 320b, 320c, and 320e may further include various components. Further, the audio amplifiers 320a, 320b, 320c, and 320e may have other various electrical connections than the proposed connection.

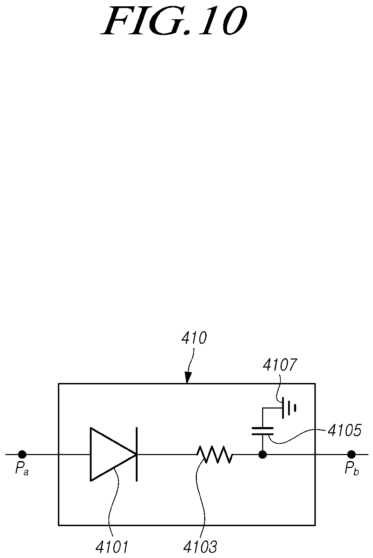

FIG. 10 is a circuit diagram illustrating a rectifier (e.g., the rectifier 410 of FIGS. 8A to 8E) included in the audio device of FIGS. 8A to 8E.

Referring to FIG. 10, the rectifier 410 may be configured as a low pass filter. However, the disclosure is not limited thereto, and various types of filter circuits may be included. For example, the rectifier 410 may be configured by a combination of various passive elements (e.g., resistance, capacitance, and inductance) other than the illustrated circuit.

According to an embodiment, the rectifier 410 may include a diode 4101, a resistor 4103, a capacitance 4105, or a plurality of terminals. The plurality of terminals may include, e.g., an input terminal Pₐ of the rectifier 410, an output terminal P_{b} of the rectifier 410, or a ground terminal 4107 of the rectifier 410.

The diode 4101 may be connected in a forward direction between the input terminal Pₐ and the output terminal P_{b}. The anode of the diode 4101 may be electrically connected to the input terminal Pₐ. The cathode of the diode 4101 may be electrically coupled to the output terminal P_{b}.

The resistor 4103 may be connected in series between the output terminal (e.g., the cathode) of the diode 4101 and the output terminal P_{b} of the rectifier 410.

The capacitance 4105 may be connected in series between the output terminal P_{b} of the diode 4101 and the ground terminal 4107 of the diode 4101. The rectifier 410 may rectify a signal obtained on the digital interface 350. The rectifier 410 may output the DC voltage obtained through the rectification as a switching control signal EN (e.g., a short (close, connect, or turn on) signal) to control the switching operation of the switch part (e.g., the switch part 330 of FIGS. 8A to 8E). The digital interface 350 may be, e.g., a signal transmission path electrically connecting a signal processor (e.g., the signal processor 311 of FIG. 8A) and the audio amplifier 320. The digital interface 350 may be, e.g., a signal transmission path electrically connecting the processor (e.g., the processor 310b, 310c, or 310e of FIG. 8B, 8C, or 8E) and the signal processor (e.g., the signal processor 321 of FIG. 8A, 8C, or 8E). The digital interface 350 may be, e.g., a signal transmission path electrically connecting the signal processor (e.g., the signal processor 311 of FIG. 8D) included in the processor (e.g., the processor 310d of FIG. 8D) and the signal processor (e.g., the signal processor 321 of FIG. 8D) included in the audio amplifier 320d.

For example, in a section (e.g., section (a) of FIG. 5 or section (a) of FIG. 7) in which a digital audio signal is not output to the digital interface 350 by a processor (e.g., the processor 310a, 310b, 310c, 310d, or 310e of FIGS. 8A to 8E), the rectifier 410 may output a low-level switching control signal (DIS) (e.g., open, disconnection, or off) because only a signal corresponding to audible noise exists but there is no voltage to be substantially rectified.

The rectifier 410 may obtain a digital audio signal at any point of the digital interface 350, e.g., in a section (e.g., section (b) of FIG. 5 or section (b) of FIG. 7) in which a digital audio signal is output to the digital interface 350 by a processor (e.g., the processor 310a, 310b, 310c, 310d, or 310e of FIGS. 8A to 8E). The digital audio signal obtained on the digital interface 350 may be a pulsed electrical signal. The rectifier 410 may convert the digital audio signal into a DC voltage having a predetermined level by the charging/discharging operation of the internal capacitor 4105. The DC voltage may be used as, e.g., a switching control signal EN (e.g., a short (close, connect, or turn on) signal) to control a switching operation of a switch part (e.g., the switch part 330 of FIGS. 8A to 8E).

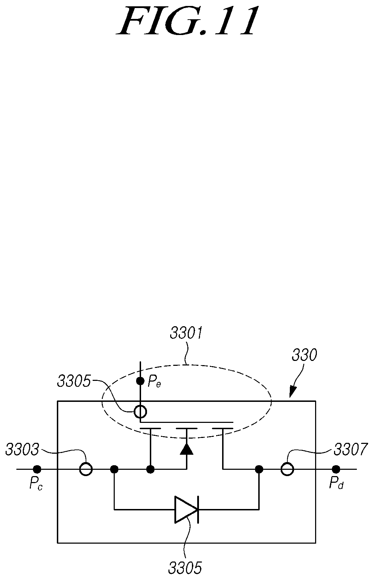

FIG. 11 is a circuit diagram illustrating a switch part (e.g., the switch part 330 of FIGS. 8A to 8E) included in an audio device (e.g., the audio device 300a, 300b, 300c, 300d, or 300e of FIGS. 8A to 8E) of FIGS. 8A to 8E.

Referring to FIG. 11, the switch part 330 may include a switch element 3310, a diode 3320, or a plurality of terminals. The plurality of terminals may include, e.g., at least one input terminal P_{c}, at least one output terminal P_{d}, or at least one control terminal Pₑ.

The diode 3320 may be disposed to connect the at least one input terminal P_{c} and the at least one output terminal P_{d} in a forward direction.

An electric field effect transistor (FET) may be used as the switch element 3310. In an embodiment, the FET used as the switch element 3310 may be a metal oxide semiconductor field effect transistor (MOSFET). However, the disclosure is not limited thereto, and various types of electronic elements that switch by external control may be used as the switch element 3310. The MOSFET used as the switch element 3310 may include a source terminal 3303, a gate terminal 3305, or a drain terminal 3307. The source terminal 3303 may correspond to the input terminal P_{c} of the switch part 330. The gate terminal 3305 may correspond to the control terminal Pₑ of the switch part 330. The drain terminal 3307 may correspond to the output terminal P_{d} of the switch part 330.

The at least one input terminal P_{c} (e.g., the source terminal 3303 of the MOSFET) may be connected to an audio amplifier (e.g., the audio amplifier 320 of FIG. 3, FIG. 4, or FIG. 6). The audio signal amplified by the audio amplifier 320 may be input to the at least one input terminal P_{c}. The audio signal amplified by the audio amplifier 320 may be transferred to an input terminal (e.g., the source terminal 3303 of the MOSFET) of the switch element 3310.

A switching control signal for controlling a switching operation of the switch part 330 may be input to the at least one control terminal Pₑ (e.g., the gate terminal 3305 of the MOSFET). In an embodiment, the at least one control terminal Pₑ may be connected to a processor (e.g., the processor 310-1 of FIG. 3). A switching control signal output by the processor 310-1 may be input to the at least one control terminal Pₑ. In an embodiment, the at least one control terminal Pₑ may be connected to a rectifier (e.g., the rectifier 410 of FIG. 4). A switching control signal output by the rectifier 410 may be input to the at least one control terminal Pₑ. In an embodiment, the at least one control terminal Pₑ may be connected to an adjustment part (e.g., the adjustment part 610 of FIG. 6). A switching control signal output by the adjustment part 610 may be input to the at least one control terminal Pₑ. The switching control signal may control a switching operation of the switch element 3310.

The at least one output terminal P_{d} (e.g., the drain terminal 3307 of the MOSFET) may be connected to a sound output (e.g., the sound output 340 of FIG. 3, FIG. 4, or FIG. 6). The audio signal output to the at least one output terminal P_{d} by the switch part 330 may be transferred as an input of the sound output 340.

In an embodiment, the switching control signal input to the control terminal Pₑ (e.g., the gate terminal 3305 of the MOSFET) of the switch part 330 may be one of an enable (EN) signal or a disable (DIS) signal. The enable (EN) signal may have a voltage larger than or equal to a predetermined voltage level. If the enable (EN) signal is input to the control terminal Pₑ (e.g., the gate terminal 3305 of the MOSFET) of the switch part 330, the switch element 3310 may be turned on. If the switch element 3310 is turned on, an electrical path (channel) may be formed between an input terminal (e.g., the source terminal 3303 of the MOSFET) and an output terminal (e.g., the drain terminal 3307 of the MOSFET) of the switch element 3310. An electrical signal may flow through the channel. This state may be referred to as a shorted state of the switch part 330. The disable (DIS) signal may have a voltage lower than a predetermined voltage level. If the disable (DIS) signal is input to the control terminal Pₑ (e.g., the gate terminal 3305 of the MOSFET) of the switch part 330, the switch element 3310 may be turned off. If the switch element 3310 is turned off, an electrical path (channel) may not be formed between an input terminal (e.g., the source terminal 3303 of the MOSFET) of the switch element 3310 and an output terminal (e.g., the drain terminal 3307 of the MOSFET). This state may be referred to as an open state of the switch part 330.

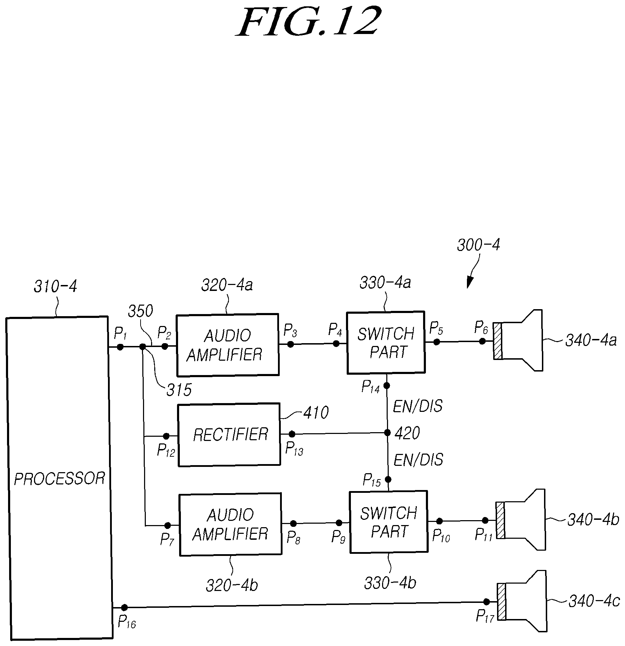

FIG. 12 is a block diagram illustrating an audio device 300-4 in an electronic device (e.g., the electronic device 101 of FIG. 1) according to an embodiment of the disclosure.

Referring to FIG. 12, the audio device 300-4 may include a processor 310-4, a plurality of audio amplifiers 320-4a and 320-4b, a plurality of switch parts 330-4a and 330-4b, a plurality of sound outputs 340-4a, 340-4b, 340-4c, or a rectifier 410. The plurality of audio amplifiers 320-4a and 320-4b may include, e.g., a first audio amplifier 320-4a or a second audio amplifier 320-4b. The plurality of switch parts 330-4a and 330-4b may include a first switch part 330-4a or a second switch part 330-4b. The plurality of sound outputs 340-4a, 340-4b, and 340-4c may include a first sound output 340-4a, a second sound output 340-4b, or a third sound output 340-4c. The first sound output 340-4a may correspond to, e.g., an upper speaker of an electronic device (e.g., the electronic device 101 of FIG. 1). The second sound output 340-4b may correspond to, e.g., a lower speaker of the electronic device 101. The third sound output 340-4c may be, e.g., a USB terminal (e.g., the connecting terminal 178 of FIG. 1) of the electronic device 101. Various types of sound output devices (e.g., earphones, headphones, and speakers) may be connected to the third sound output 340-4c. However, the sound output device is not limited thereto, and may include various types of sound outputs.

The output terminal P₁ of the processor 310-4 may be electrically connected to the input terminal P₂ of the first audio amplifier 320-4a. The output terminal P₃ of the first audio amplifier 320-4a may be electrically connected to the input terminal P₄ of the first switch part 330-4a. The output terminal P₅ of the first switch part 330-4a may be electrically connected to the input terminal P₆ of the first sound output 340-4a. The output terminal P₁₆ of the processor 310-4 may be electrically connected to the input terminal P₁₇ of the third sound output 340-4c.

The input terminal P₇ of the second audio amplifier 320-4b may be electrically connected to any point on the digital interface 350 that electrically connects the processor 310-4 and the first audio amplifier 320-4a. The output terminal P₈ of the second audio amplifier 320-4b may be electrically connected to the input terminal P₉ of the second switch part 330-4b. The output terminal P₁₀ of the second switch part 330-4b may be electrically connected to the input terminal P₁₁ of the second sound output 340b.

The input terminal P₁₂ of the rectifier 410 may be electrically connected to any point on the digital interface 350 that electrically connects the processor 310-4 and the first audio amplifier 320-4a. The output terminal P₁₃ of the rectifier 410 may be electrically connected to any point 420 of a line electrically connecting the input terminal P₁₄ of the first switch part 330-4a and the input terminal P₁₅ of the second switch part 330-4b.

The processor 310-4 may output a digital audio signal to the digital interface 350. The digital audio signal output from the processor 310-4 and flowing on the digital interface 350 may be a digital interface signal.

If the digital audio signal is output to the output terminal P₁ by the processor 310-4, the digital audio signal may flow through the digital interface 350 electrically connecting the output terminal P₁ of the processor 310-4 and the input terminal P₂ of the first audio amplifier 320-4a. The digital audio signal flowing on the digital interface 350 may also be transferred to the input terminal P₁₂ of the rectifier 410.

The rectifier 410 may output a switching control signal by a digital audio signal output from the processor 310-4 through the digital interface 350. For example, if there is a digital audio signal flowing through the digital interface 350, the rectifier 410 may output a switching control signal (enable (EN)) for shorting the first switch part 330-4a and/or the second switch part 330-4b. The shorting of the first switch part 330-4a electrically connects the first audio amplifier 320-4a and the first sound output 340-4a. The shorting of the second switch part 330-4b electrically connects the second audio amplifier 320-4b and the second sound output 340-4b. For example, if there is no digital audio signal flowing through the digital interface 350, the rectifier 410 may output a switching control signal (DIS) for opening the first switch part 330-4a and/or the second switch part 330-4b. The opening of the first switch part 330-4a electrically cuts off the first audio amplifier 320-4a and the first sound output 340-4a. The opening of the second switch part 330-4b electrically cuts off the second audio amplifier 320-4b and the second sound output 340-4b.

The digital audio signal output from the processor 310-4 and flowing on the digital interface 350 may be transferred to the input terminal P₂ of the first audio amplifier 320-4a and/or the input terminal P₇ of the second audio amplifier 320-4b.

The digital audio signal transferred from the processor 310-4 through the digital interface 350 may be amplified by the first audio amplifier 320-4a and/or the second audio amplifier 320-4b, or may be converted into an analog audio signal and then amplified. The digital audio signal may be amplified or attenuated in the whole or partial frequency band by, e.g., the first audio amplifier 320-4a or the second audio amplifier 320-4b.

The audio signal output to the output terminal P₃ of the first audio amplifier 320-4a may be transferred to the input terminal P₄ of the first switch part 330-4a. The audio signal transferred to the input terminal P₄ of the first switch part 330-4a may be output to the output terminal P₅ by the switching operation of the first switch 330-4a. The audio signal output to the output terminal P₅ of the first switch 330-4a may be transferred to the input terminal P₆ of the first sound output 340-4a. The audio signal input to the first sound output 340-4a may be an analog signal and be output as a sound signal.

The audio signal output to the output terminal P₈ of the second audio amplifier 320-4b may be transferred to the input terminal P₉ of the second switch part 330-4b. The audio signal transferred to the input terminal P₉ of the second switch part 330-4b may be output to the output terminal P₁₀ by the switching operation of the second switch part 330-4b. The audio signal output to the output terminal P₁₀ of the second switch part 330-4b may be transferred to the input terminal P₁₁ of the second sound output 340-4b. The audio signal input to the second sound output 340-4b is an analog signal and may be output as a sound signal.

Although not shown, the processor 310-4 may further include a switching element. The processor 310-4 may detect whether the sound output device is electrically connected to the third sound output 340-4c. If the sound output device is electrically connected to the third sound output 340-4c, the processor 310-4 may control the switching element to output the sound signal only to the third sound output 340-4c to which the sound output device is electrically connected.

In an embodiment, if the sound output device is electrically connected to the third sound output 340-4c, the processor 310-4 may output an audio signal to the output terminal P₁₆. The audio signal output by the processor 310-4 may be transferred from the output terminal P₁₆ to the input terminal P₁₇ of the third sound output 340-4c. The audio signal may include, e.g., a digital signal. The audio signal may be output as a sound signal by, e.g., a sound output device (e.g., an earphone) connected to the third sound output 340-4c.

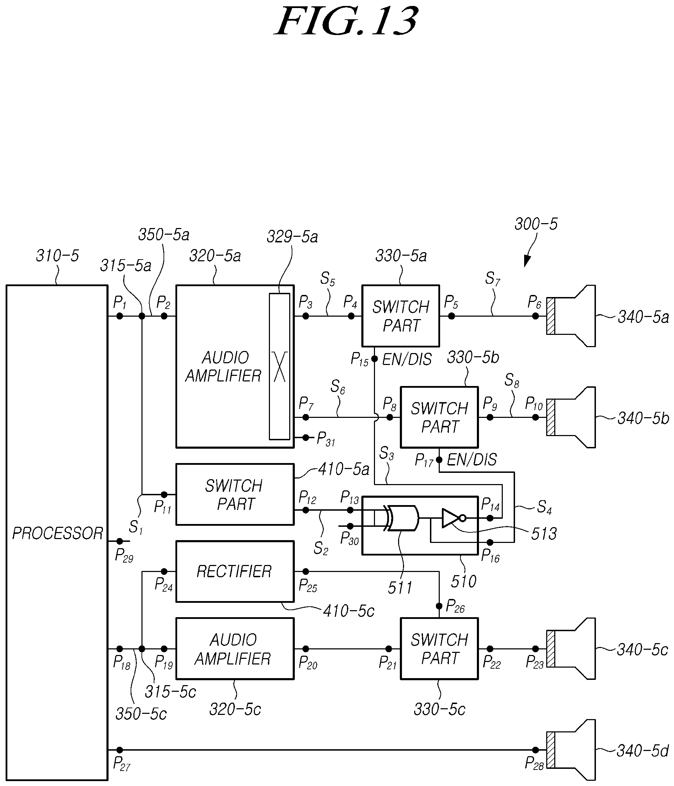

FIG. 13 is a block diagram illustrating an audio device 300-5 in an electronic device (e.g., the electronic device 101 of FIG. 1) according to an embodiment of the disclosure.

Referring to FIG. 13, the audio device 300-5 may include a processor 310-5, a plurality of audio amplifiers 320-5a and 320-5c, a plurality of switch parts 330-5a, 330-5b, and 330-5c, a plurality of rectifiers 410-5a and 410-5c, a signal divider 510, or a plurality of sound outputs 340-5a, 340-5b, 340-5c, and 340-5d.

The plurality of audio amplifiers 320-5a and 320-5c may include a first audio amplifier 320-5a or a second audio amplifier 320-5c. The first audio amplifier 320-5a may include a switching element 329-5a.

The plurality of switch parts 330-5a, 330-5b, and 330-5c may include a first switch part 330-5a, a second switch part 330-5b, or a third switch part 330-5c. The plurality of rectifiers 410-5a and 410-5c may include a first rectifier 410-5a or a second rectifier 410-5c.

The plurality of sound outputs 340-5a, 340-5b, 340-5c, and 340-5d may include a first sound output 340-5a, a second sound output 340-5b, a third sound output 340-5c, or a fourth sound output 340-5d. The first sound output 340-5a may be, e.g., an upper receiver of an electronic device (e.g., the electronic device 101 of FIG. 1). The second sound output 340-5b may be, e.g., a 3.5 mm earphone insertion terminal (the connecting terminal 178 of FIG. 1) of the electronic device 101. A cable connecting a sound device such as an earphone, a headphone, or a speaker may be connected to the second sound output 340-5b. The third sound output 340-5c may be, e.g., a lower speaker. The fourth sound output 340-5d may be, e.g., a USB terminal (e.g., the connecting terminal 178 of FIG. 1) of the electronic device 101. Various types of sound devices (e.g., earphones, headphones, and speakers) may be connected to the fourth sound output 340-5d. However, the plurality of sound devices are not limited thereto and may include various types of sound devices.

The output terminal P₁ of the processor 310-5 may be electrically connected to the input terminal P₂ of the first audio amplifier 320-5a or the input terminal P₁₁ of the first rectifier 410-5a. The digital interface 350 electrically connecting the output terminal P₁ of the processor 310-5 to the input terminal P₂ of the first audio amplifier 320-5a or the input terminal P₁₁ of the first rectifier 410-5a may be branched at any point 315-5a.

The output terminal P₁₈ of the processor 310-5 may be electrically connected to the input terminal P₁₉ of the second audio amplifier 320-5c or the input terminal P₂₄ of the second rectifier 410-5c. A digital interface electrically connecting the output terminal P₁₈ of the processor 310-5 to the input terminal P₁₉ of the second audio amplifier 320-5c or the input terminal P₂₄ of the second rectifier 410-5c may be branched at any point 315-5c.

The output terminal P₂₇ of the processor 310-5 may be electrically connected to the input terminal P₂₈ of the fourth sound output 340-5d. The output terminal P₂₉ of the processor 310-5 may be electrically connected to the input terminal P₃₀ of the signal divider 510. Alternatively, the output terminal P₃₁ of the audio amplifier 320-5a may be electrically connected to the input terminal P₃₀ of the signal divider 510.

The output terminal P₃ of the first audio amplifier 320-5a may be electrically connected to the input terminal P₄ of the first switch part 330-5a. The output terminal P₇ of the first audio amplifier 320-5a may be electrically connected to the input terminal P₈ of the second switch part 330-5b.

The output terminal P₅ of the first switch part 330-5a may be electrically connected to the input terminal P₆ of the first sound output 340-5a. The control terminal P₁₅ of the first switch part 330-5a may be electrically connected to the output terminal P₁₄ of the signal divider 510.

The output terminal P₉ of the second switch part 330-5b may be electrically connected to the input terminal P₁₀ of the second sound output 340-5b. The control terminal P₁₇ of the second switch part 330-5b may be electrically connected to the output terminal P₁₆ of the signal divider 510.

The output terminal P₁₂ of the first rectifier 410-5a may be electrically connected to the input terminal P₁₃ of the signal divider 510.

The output terminal P₂₀ of the second audio amplifier 320-5c may be electrically connected to the input terminal P₂₁ of the third switch part 330-5c. The output terminal P₂₂ of the third switch part 330-5c may be electrically connected to the input terminal P₂₃ of the third sound output 340-5c. The control terminal P₂₆ of the third switch part 330-5c may be electrically connected to the output terminal P₂₅ of the second rectifier 410-5c.

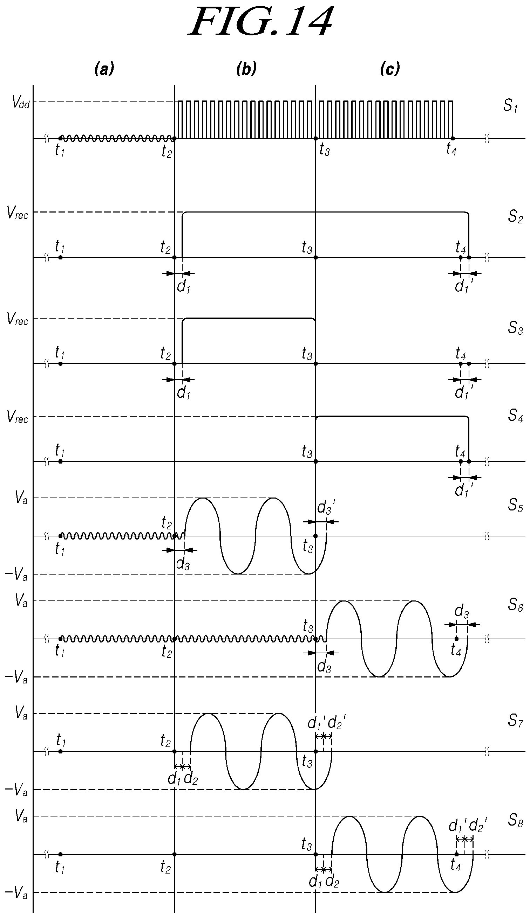

According to an embodiment, an electrical signal may be generated in each component of the audio device 300-5. The electrical signal may include an audio signal or a switching control signal. The first electrical signal S₁ may be, e.g., an audio signal transferred from the output terminal P₁ of the processor 310-5 to the input terminal P₂ of the first audio amplifier 320-5a or transferred to the input terminal P₁₁ of the first rectifier 410-5a. The second electrical signal S₂ may be, e.g., an audio signal transferred from the output terminal P₁₂ of the first rectifier 410-5a to the input terminal P₁₃ of the signal divider 510. The third electrical signal S₃ may be, e.g., a switching control signal transferred from the output terminal P₁₄ of the signal divider 510 to the control terminal P₁₅ of the first switch part 330-5a. The fourth electrical signal S₄ may be, e.g., a switching control signal transferred from the output terminal P₁₆ of the signal divider 510 to the control terminal P₁₇ of the second switch part 330-5b. The fifth electrical signal S₅ may be, e.g., an audio signal transferred from the output terminal P₃ of the first audio amplifier 320-5a to the input terminal P₄ of the first switch part 330-5a. The sixth electrical signal S₆ may be, e.g., an audio signal transferred from the output terminal P₇ of the first audio amplifier 320-5a to the input terminal P₈ of the second switch part 330-5b. The seventh electrical signal S₇ may be, e.g., an audio signal transferred from the output terminal P₅ of the first switch part 330-5a to the input terminal P₆ of the first sound output 340-5a. The eighth electrical signal S₈ may be, e.g., an audio signal transferred from the output terminal P₉ of the second switch part 330-5b to the input terminal P₁₀ of the second sound output 340-5b. The waveform diagram of the first to eighth electrical signals S₁, S₂, S₃, S₄, S₅, S₆, S₇, and S₈ is described with reference to FIG. 14. Among the first to eighth electrical signals S₁, S₂, S₃, S₄, S₅, S₆, S₇, and S₈, the first and second electrical signals S₁ and S₂ and the fifth to eighth electrical signals S₅, S₆, S₇, and S₈ may be audio signals, and the third and fourth electrical signals S₃ and S₄ may be switching control signals. Although not illustrated, audio signals flowing between the processor 310-5 and the third sound output 340-5c may correspond to the waveform diagram of FIG. 5.

According to an embodiment, the processor 310-5 may output the digital audio signal to the output terminal P₁. The digital audio signal output to the output terminal P₁ of the processor 310-5 may be input to the input terminal P₂ of the first audio amplifier 320-5a through the digital interface 350-5a.

The digital audio signal output to the output terminal P₁ of the processor 310-5 may be branched at an arbitrary point 315-5a on the digital interface 350-5a and input to the input terminal P₁₁ of the first rectifier 410-5a. The first audio amplifier 320-5a may convert a digital audio signal input through the input terminal P₂ into an analog audio signal. The first audio amplifier 320-5a may amplify or attenuate the entire or partial frequency band of the converted analog audio signal.

The first audio amplifier 320-5a may perform signal processing such as signal conversion, amplification, or attenuation on the digital audio signal input through the input terminal P₂ and output the signal to the output terminal P₃. The audio signal output to the output terminal P₃ of the first audio amplifier 320-5a may be input to the input terminal P₄ of the first switch part 330-5a. The first switch part 330-5a may output the audio signal input to the input terminal P₄ to the output terminal P₅ in response to the first switching control signal input to the control terminal P15. For example, the first switching control signal may be output through the output terminal P₁₄ of the signal divider 510 and then transferred to the control terminal P₁₅ of the first switch part 330-5a. The audio signal output to the output terminal P₅ of the first switch part 330-5a may be input to the input terminal P₆ of the first sound output 340-5a. The first sound output 340-5a may output an audio signal input to the input terminal P₆ as a sound signal.

The first audio amplifier 320-5a may output an audio signal on which signal processing such as signal conversion, amplification, or attenuation is performed to the output terminal P₇. The audio signal output to the output terminal P₇ of the first audio amplifier 320-5a may be input to the input terminal P₈ of the second switch part 330-5b. The second switch part 330-5b may output the audio signal input to the input terminal P₈ to the output terminal P₉ in response to the second switching control signal input to the control terminal P₁₇. For example, the second switching control signal may be output through the output terminal P₁₆ of the signal divider 510 and then transferred to the control terminal P₁₇ of the second switch part 330-5b. The audio signal output to the output terminal P₉ of the second switch part 330-5b may be input to the input terminal P₁₀ of the second sound output 340-5b. The second sound output 340-5b may output an audio signal input to the input terminal P₁₀ as a sound signal.

In an embodiment, the first audio amplifier 320-5a may include a switching element 329-5a for adaptively selecting an output terminal P₃ or P₇ to output a digital audio signal. The switching element 329-5a of the first audio amplifier 320-5a may output a digital audio signal to the output terminal P₃ or to the output terminal P₇ depending on whether the sound device is electrically connected to the second sound output 340-5b. For example, if the sound device is not electrically connected to the second sound output 340-5b, the switching element 329-5a of the first audio amplifier 320-5a may output the digital audio signal to the output terminal P₃. For example, if the sound device is electrically connected to the second sound output 340-5b, the switching element 329-5a of the first audio amplifier 320-5a may output the digital audio signal to the output terminal P₇.

The first rectifier 410-5a may rectify the digital audio signal input through the input terminal P₁₁ to output a switching control signal which is a DC component having a predetermined voltage level. The switching control signal may include, e.g., a high-level section (e.g., a switch-on operation section) or a low-level section (e.g., a switch-off operation section). In an embodiment, if there is a digital audio signal to be output from the processor 310-5, the first rectifier 410-5a may output a switching control signal (enable (EN)) for shorting the first switch 330-5a or the second switch 330-5b. For example, if there is no digital audio signal, the first rectifier 410-5a may output a switching control signal (disable (DIS)) for opening the first switch 330-5a or the second switch 330-5b.

The first rectifier 410-5a may output the switching control signal through the output terminal P₁₂. The switching control signal output through the output terminal P₁₂ of the first rectifier 410-5a may be input to the input terminal P₁₃ of the signal divider 510. An identification signal output through the output terminal P₂₉ of the processor 310-5 may be input to the input terminal P₃₀ of the signal divider 510. Alternatively, the identification signal may be input to the input terminal P₃₀ of the signal divider 510 through the output terminal P₃₁ of the audio amplifier 320-5a. The identification signal may be a signal indicating whether a sound device (e.g., an earphone) is connected to the second sound output 340-5b (e.g., the connecting terminal 178 of FIG. 1). The identification signal may be, e.g., one of a low-level voltage indicating that the sound device is connected to the second sound output 340-5b or a high-level voltage indicating that the sound device is not connected to the second sound output 340-5b.

The signal divider 510 may output a first switching control signal SW #1 and a second switching control signal SW #2 using the switching control signal I₂ input to the input terminal P₁₃ and the identification signal I₁ input to the input terminal P₃₀. For example, the signal divider 510 may output the first switching control signal SW #1 to the output terminal P₁₄, and may output the second switching control signal SW #2 to the output terminal P₁₆. In an embodiment, the first switching control signal SW #1 may be an inverted signal of the switching control signal input to the input terminal P₁₃, and the second switching control signal SW #2 may be a switching control signal input to the input terminal P₁₃.

According to an embodiment, the signal divider 510 may be configured as a logic circuit block. The signal divider 510 may be designed by, e.g., two logic gates. For example, the signal divider 510 may be configured by serially connecting an input of an inverter (NOT logical operator or an inverse (INV) logical operator) 513 to an output terminal of an exclusive OR (XOR) 511. However, the disclosure is not limited thereto, and the signal divider 510 may be configured by combining various logic gates. A switching control signal I₂ may be input to a first input terminal (e.g., input terminal P₁₃) of the exclusive OR gate XOR 511. The identification signal I₁ may be input to the second input terminal (e.g., the input terminal P₃₀) of the exclusive OR gate XOR 511.

In an embodiment, if the switching control signal I₂ and the identification signal I₁ have the same value (e.g., a high level or a low level), the exclusive OR gate XOR 511 may output a low-level switching control signal (e.g., the second switching control signal SW #2). If the switching control signal I₂ and the identification signal I₁ have different values (e.g., a high level and a low level or a low level and a high level), the exclusive OR gate XOR 511 may output a high-level switching control signal (e.g., the second switching control signal SW #2). The processor 310-5 may output, e.g., a high-level switching control signal I₂ when there is an output of a digital audio signal. The processor 310-5 may output, e.g., a low-level switching control signal I₂ when there is no output of the digital audio signal. The processor 310-5 may output, e.g., a low-level identification signal I₁ when the sound device is connected to the second sound output 340-5b. The processor 310-5 may output, e.g., a high-level identification signal I₁ when the sound device is not connected to the second sound output 340-5b.

In an embodiment, the inverter (NOT logical operator) 513 may output a switching control signal (e.g., the first switching control signal SW #1) inverted from a switching control signal (e.g., the second switching control signal SW #2) output by the exclusive OR gate (XOR logical operator) 511.

Table 1 below is a table showing a condition table according to the operation of the signal divider 510.

**[Table 1]**

| | Whether earphone is connected (I₁) | Whether to input EN signal to P₁₃ terminal (I₂) | Whether to output EN signal to P₁₄ terminal (SW #1) | Whether to output EN signal to P₁₆ terminal (SW #2) |
|---|---|---|---|---|
| Output to first sound output | H | H | H | L |
| Output to second sound output | L | H | L | H |
| Not output to first sound output | H | L | L | H |
| Not output to second sound output | L | L | H | L |

In Table 1, "whether earphone is connected (I₁)" may be an identification signal according to detection of whether a sound output device (e.g., earphone) is connected to the second sound output 340-5b (e.g., the connecting terminal 178 of FIG. 1). For example, if "whether earphone is connected (I₁)" is a high signal H, the state in which the earphone is not connected to the second sound output 340-5b may be indicated. For example, if "whether earphone is connected (I₁)" is a low signal L, the state in which the earphone is connected to the second sound output 340-5b may be indicated.

In Table 1, "whether to input EN signal to P₁₃ terminal (I₂)" may be a signal according to whether the enable (EN) signal is output to the output terminal P₁₂ of the first rectifier 410-5a and input to the input terminal P₁₃ of the signal divider 510. The enable (EN) signal may be generated when there is a digital audio signal. For example, if "whether to output EN signal to P₁₃ terminal (I₂)" is H, the enable (EN) signal may be output to the output terminal P₁₂ of the first rectifier 410a and input to the input terminal P₁₃ of the signal divider 510. If "whether to output EN signal to P₁₃ terminal (I₂)" is L, it may correspond to the disable (DIS) signal being output to the output terminal P₁₂ of the first rectifier 410a and being input to the input terminal P₁₃ of the signal divider 510.

If the "whether earphone is connected" signal I₁ and the "whether to output EN signal to P₁₃ terminal" signal I₂ pass through the XOR gate 511, the "whether to output EN signal to P₁₆ terminal (SW #2)" may be output to the output terminal P₁₆ of the signal divider 510. If "whether to output the EN signal to P₁₆ terminal (SW #2)" is output as the H signal, the enable (EN) signal may be output to the output terminal P₁₆ of the signal divider 510. If "whether to output EN signal to P₁₆ terminal (SW #2)" is output as the L signal, the disable (DIS) signal may be output to the output terminal P₁₆ of the signal divider 510.

If the "whether earphone is connected" signal I₁ and the "whether to output EN signal to P₁₂ terminal" signal I₂ pass through the exclusive OR (XOR) gate 511 and the passing signal passes through the Inverse (INV) gate 513, the "whether to output EN signal to P₁₄ terminal (SW #1)" may be output to the output terminal P₁₄ of the signal divider 510. The signal SW #1 output to the output terminal P₁₄ may be an inverted (inverse) signal with respect to the signal SW #2 output to the output terminal P₁₆. For example, if the H signal is output to the output terminal P₁₆, the L signal may be output to the output terminal P₁₄. If the L signal is output to the output terminal P₁₆, the H signal may be output to the output terminal P₁₄. For example, if "whether to output EN signal to P₁₆ terminal (SW #2)" is output as the H signal, the enable (EN) signal may be output to the second output terminal of the signal divider 510. If "whether to output EN signal to P₁₆ terminal (SW #2)" is output as the L signal, the disable (DIS) signal may be output to the P₁₆ terminal.

The enable (EN) signal output to the output terminal P₁₄ of the signal divider 510 may be input to the input terminal P₁₅ of the first switch part 330-5a. The enable (EN) signal may control the first switch 330-5a to be shorted. The disable (DIS) signal output to the output terminal P₁₄ of the signal divider 510 may be input to the input terminal P₁₅ of the first switch part 330-5a. The disable (DIS) signal may control the first switch part 330-5a to be opened. The enable (EN) signal output to the output terminal P₁₆ of the signal divider 510 may be input to the input terminal P₁₇ of the second switch part 330-5b. The enable (EN) signal may control the second switch 330-5b to be shorted. The disable (DIS) signal output to the output terminal P₁₆ of the signal divider 510 may be input to the input terminal P₁₇ of the second switch part 330-5b. The disable (DIS) signal may control the second switch part 330-5b to be opened.

The switching control signals SW #1 and SW #2 output by the signal divider 510 may allow a sound signal to be output from any one of the first sound output 340-5a or the second sound output 340-5b. For example, if an earphone is connected to an earphone terminal (e.g., the second sound output 340-5b), a sound signal (e.g., music being played or a call sound) is output only through the earphone. If an earphone is not connected to the earphone terminal (e.g., the second sound output 340-5b), a sound signal is output only through an upper receiver (e.g., the first sound output 340-5a).

Further, the electrical connection and the electrical signal movement relationship between the second audio amplifier 320-5c, the second rectifier 410-5c, the third switch 330-5c, or the third sound output 340-5c are the same as those described with reference to FIG. 4, and thus a detailed description thereof is omitted. The electrical connection and the electrical signal movement relationship between the processor 310-5 and the fourth sound output 340-5d are also the same as those described with reference to FIG. 12, and thus a detailed description thereof is omitted.

FIG. 14 is a waveform diagram illustrating electrical signals S₁ to S₈ flowing through the respective lines of the audio device 300-5 in FIG. 13.

Referring to FIG. 14, section (a) may be a section in which there is no digital audio signal output to a digital interface (e.g., the digital interface 350-5a of FIG. 13) by a processor (e.g., the processor 310-5 of FIG. 13) of the audio device 300-5. Section (a) may be, e.g., a section in which the audio device 300-5 operates in an idle state. If there is no input audio signal, the audio device 300-5 may operate in the idle state.

Section (b) may be a section in which there is a digital audio signal output to the digital interface 350-5a by the processor 310-5. Section (b) may be, e.g., a section in which the audio device 300-5 operates in an active state. If there is an input audio signal, the audio device 300-5 may operate in the active state. Section (b) may be, e.g., a section in which an audio signal output to the first sound output 340-5a is present because a sound output device (e.g., an earphone) is not connected to the second sound output 340-5b.

Section (c) may be a section in which there is a digital audio signal output to the digital interface 350-5a by the processor 310-5. Section (c) may be, e.g., a section in which the audio device 300-5 operates in the active state. If there is an input audio signal, the audio device 300-5 may operate in the active state. Section (c) may be, e.g., a section in which a sound output device (e.g., an earphone) is connected to the second sound output 340-5b and an audio signal output to the second sound output 340-5b is present.

The signal S₁ may be an audio signal flowing from the processor 310-5 toward the first audio amplifier 320-5a. The signal S₁ may be an audio signal flowing from an arbitrary point 315-5a on the digital interface 350-5a between the processor 310-5 and the first audio amplifier 320-5a to the input terminal P₁₁ of the first rectifier 410-5a.

The fine electrical signal that may be present in section (a) (e.g., time points t₁ to t₂) may correspond to audible noise. The audible noise signal may be generated by, e.g., an electrical signal generated by an element or component disposed around the audio device 300-5 and/or an electrical signal flowing through a conductive line passing around the audio device 300-2. A pulsed electrical signal that may be present in section (b) to section (c) (e.g., time points t₂ to t₄) may correspond to a digital audio signal. For example, the digital audio signal may be output by the processor 310-5 to the digital interface 350-5a through the output terminal P₁. The digital audio signal may have, e.g., a pulse form in which +V_{dd} is an upper level and 0 is a lower level.

The signal S₂ may be an audio signal flowing from the output terminal P₁₂ of the first rectifier 410-5a to the input terminal P₁₃ of the signal divider 510. If a fine electrical signal passes through the first rectifier 410-5a in section (a), an audio signal having a voltage of 0V may be output. The audio signal may correspond to a disable (DIS) signal for controlling to open the switch part 330. If the pulsed signal S₁ having an upper limit level +V_{dd} and a lower limit level 0 passes through the rectifier 410 in section (b) to section (c) (e.g., from time point t₂+d₁ to time point t₄+d₁'), the signal S₂ may be converted into a digital audio signal having a constant voltage. The constant voltage may correspond to V_{rec}. If V_{rec} is a digital audio signal of a predetermined voltage value or more, V_{rec} may correspond to an enable (EN) signal for controlling to short the switch part 330. The audio signal converted by the rectifier 410 may not have a voltage value sufficient to short or open the switch part 330. d₁ or d₁' may correspond to a delay time. The delay time may correspond to a time required for the signal S₁ to be processed as the signal S₂ by the rectifier 410. The delay time may be a delay time. d₁ and d₁' may or may not be the same. d₁ and d₁' may correspond to substantially small values close to zero. Therefore, the user may not feel the delay time.

The signal S₃ may be an audio signal flowing from the output terminal P₁₄ of the signal divider 510 to the input terminal P₁₅ of the switch part 330-5a.

If the signal S₂ passes through the signal divider 510 in section (a), the signal S₃ may output an audio signal having a voltage of 0V at the output terminal P₁₄ of the signal divider 510. The audio signal may correspond to a disable (DIS) signal for controlling to open the first switch part 330-5a. If the signal S₂ passes through the signal divider 510 in section (b) (e.g., from t₂+d₁ to t₃), an audio signal having a constant voltage of V_{rec} may be output to the output terminal P₁₄ of the signal divider. The output signal may be an H signal output from the output terminal P₁₄ of the signal divider 510. If signal S₂ passes through the signal divider 510 in section (c) (e.g., from t₃ to t₄), an audio signal having a voltage of 0V may be output to the output terminal P₁₄ of the signal divider. The output signal may be an L signal output from the output terminal P₁₄ of the signal divider 510.

The signal S₄ may be an audio signal flowing from the output terminal P₁₆ of the signal divider 510 to the input terminal P₁₇ of the second switch part 330-5b.

If the signal S₂ passes through the signal divider 510 in section (a), the signal S₄ may generate an audio signal having a voltage of 0V at the output terminal P₁₆ of the signal divider 510. The audio signal may correspond to a disable (DIS) signal for controlling to open the second switch part 330-5b. If the signal S₂ passes through the signal divider 510 in section (b), an audio signal having a voltage of 0V may be output to the output terminal P₁₄ of the signal divider. The output signal may be an L signal output from the output terminal P₁₄ of the signal divider 510. If the signal S₂ passes through the signal divider 510 in section (c) (e.g., from t₃ to t₄+d₁'), an audio signal having a constant voltage of V_{rec} may be output to the output terminal P₁₄ of the signal divider. The output signal may be an H signal output from the output terminal P₁₄ of the signal divider 510.

The signal S₅ may be an audio signal flowing from the output terminal P₃ of the first audio amplifier 320-5a to the input terminal P₄ of the first switch part 330-5a.

Fine electrical signals that may be present in section (a) (e.g., from time point t₁ to t₂+d₃) may correspond to audible noise. The audible noise signal may be generated by, e.g., an electrical signal generated by an element or component disposed around the audio device 300-5 and/or an electrical signal flowing through a conductive line passing around the audio device 300-2. A sinusoidal electrical signal that may be present in section (b) (e.g., from time point t₂+d₃ to time point t₃+d₃') may correspond to an analog audio signal or a digital audio signal. The electrical signal may include, e.g., an analog audio signal output through a receiver included in the electronic device 101 or a 3.5 mm earphone connected to the electronic device 101. The electrical signal may include, e.g., a digital audio signal in a D-class form. For example, the audio signal may be input to the first switch part 330-5a through the output terminal P₃ of the first audio amplifier 320-5a. The audio signal may have, e.g., a sinusoidal wave having +Vₐ as an upper limit level and -Vₐ as a lower limit level. For convenience of description, the waveform of the signal S₅ illustrated is illustrated as a sinusoidal wave, but is not limited thereto, and may have various amplitudes, periods, frequencies, and waveforms according to the type and kind of the audio signal. The audio signal may be cut off in section (c) (e.g., from time point t₃+d₃' to time point t₄). In section (c), the switching element (e.g., the switching element 329-5a of FIG. 13) may cut off the audio signal flowing to the first switch part 330-5a. d₃ or d₃' may be defined as a delay time required for the signal S₁ to be amplified by the audio amplifier 320-5a to the signal S₅. d₃ may be a value having a relationship of d₁≤d₃. d₃' may have a relationship of d₁'≤d₃.

The signal S₆ may be an audio signal flowing from the output terminal P₇ of the first audio amplifier 320-5a to the input terminal P₈ of the second switch part 330-5b.

The fine electrical signal that may be present in section (a) (e.g., from time point t₁ to time point t₂) or section (b) (e.g., from time point t₂ to time point t₃+d₃) may correspond to audible noise. The audible noise signal may be generated by, e.g., an electrical signal generated by an element or component disposed around the audio device 300-2 and/or an electrical signal flowing through a conductive line passing around the audio device 300-2. A sinusoidal electrical signal that may be present in section (c) (e.g., from time point t₃+d₃ to time point t₄+d₃') may correspond to an analog audio signal or a digital audio signal. The audio signal may include an analog signal output through a receiver included in the electronic device 101 or a 3.5 mm earphone connected to the electronic device 101. The audio signal may include a digital signal output in a D-class form. For example, the audio signal may be input to the second switch part 330-5b through the output terminal P₇ of the first audio amplifier 320-5a. The audio signal may have, e.g., a sinusoidal wave having +Vₐ as an upper limit level and -Vₐ as a lower limit level. For convenience of description, the waveform of the signal S₆ illustrated is illustrated as a sinusoidal wave, but is not limited thereto, and may have various amplitudes, periods, frequencies, and waveforms according to the type and kind of the audio signal. d₃ or d₃' may be defined as a delay time required for the signal S₁ to be amplified by the audio amplifier 320-5a to the signal S₆. d₃ may be a value having a relationship of d₁≤d₃. d₃' may have a relationship of d₁'≤d₃ .

The signal S₇ may be an audio signal flowing from the output terminal P₅ of the first switch part 330-5a to the input terminal P₆ of the first sound output 340-5a.

In section (a), a disable (DIS) signal for controlling to open the first switch part 330-5a may flow from the output terminal P₁₄ of the signal divider 510 to the input terminal P₁₅ of the first switch part 330-5a. In response thereto, the first switch part 330-5a may be opened. Therefore, audible noise (e.g., audible noise generated due to a fine electrical signal from the time point t₁ to the time point t₂+d₃ of S₅) generated in section (a) may be cut off.

In section (b), an enable (EN) signal for controlling to short the first switch part 330-5a may flow from the output terminal P₁₄ of the signal divider 510 to the input terminal P₁₅ of the first switch part 330-5a. In response thereto, the first switch part 330-5a may be shorted. Accordingly, the analog audio signal converted by the first audio amplifier 320-5a may be output as a sound signal through the first sound output 340-5a.

From t₂+d₁+d₂ to t₃+d₁'+d₂' in section (b), an audio signal having +Vₐ as an upper limit level and -Vₐ as a lower limit level may be generated. The audio signal may include an analog audio signal or a digital audio signal. The audio signal may include an analog signal output through a receiver included in the electronic device 101 or a 3.5 mm earphone connected to the electronic device 101. The audio signal may include a digital signal output in a D-class form. The audio signal may have a sinusoidal wave shape. However, the disclosure is not limited thereto, and the audio signal may have various amplitudes, periods, frequencies, and waveforms according to the type and kind of the audio signal. d₂ or d₂' may correspond to a predetermined delay time after the first switch part 330-5a is connected by the enable (EN) signal. The delay time may be a guard time. By setting the guard time, it is possible to prevent pop noise from occurring in the first sound output 340-5a. d₂ and d₂' may or may not be the same. d₂ and d₂' may correspond to small values substantially close to zero. Therefore, the user may not feel the delay time as much as d₁, d₁', d₂, and d₂'.

The switching element 329-5a may cut off the audio signal flowing to the first switch part 330-5a from t₃+d₁+d₂ to t₄+d₁'+d₂' in section (c). Accordingly, the output of the sound signal to the first sound output 340-5a may be cut off.

The signal S₈ may be an audio signal flowing from the output terminal P₉ of the second switch part 330-5b to the input terminal P₁₀ of the second sound output 340-5b.

In section (a), a disable (DIS) signal for controlling to open the first switch part 330-5a may flow from the output terminal P₁₆ of the signal divider 510 to the input terminal P₁₇ of the second switch part 330-5b. In response thereto, the first switch part 330-5a may be opened. Therefore, audible noise (e.g., audible noise generated due to a fine electrical signal from the time point t₁ to the time point t₃+d₃ of S₆) generated in section (a) may be cut off.

The switching element 329-5a may cut off the audio signal flowing to the second switch part 330-5b from t₂ to t₃+d₁+d₂ in section (b). Accordingly, the output of the sound signal to the second sound output 340-5b may be cut off.

An enable (EN) signal for controlling to short the second switch part 330-5b may flow from the output terminal P₁₆ of the signal divider 510 to the input terminal P₁₇ of the second switch part 330-5b from t₃+d₁+d₂ to t₄+d₁'+d₂' in section (c). In response thereto, the second switch part 330-5b may be shorted. Accordingly, the analog audio signal converted by the first audio amplifier 320-5a may be output as a sound signal through the second sound output 340-5b.

From t₃+d₁+d₂ to t₄+d₁'+d₂' in section (c), an audio signal having +Vₐ as an upper limit level and -Vₐ as a lower limit level may be generated. The audio signal may include an analog audio signal or a digital audio signal. The audio signal may include an analog signal output through a receiver included in the electronic device 101 or a 3.5 mm earphone connected to the electronic device 101. The audio signal may include a digital signal output in a D-class form. The audio signal may have a sinusoidal wave shape. However, the disclosure is not limited thereto, and the audio signal may have various amplitudes, periods, frequencies, and waveforms according to the type and kind of the audio signal. d₂ or d₂' may correspond to a predetermined delay time after the second switch part 330-5b is connected by the enable (EN) signal. The delay time may be a guard time. By setting the guard time, it is possible to prevent pop noise from occurring in the second sound output 340-5b. d₂ and d₂' may or may not be the same. d₂ and d₂' may correspond to small values substantially close to zero. Therefore, the user may not feel the delay time as much as d₁, d₁', d₂, and d₂'. d₂ may be a value having a relationship of d₁≤d₃≤d₁+d₂. d₂' may have a relationship of d₁'≤d₃'≤d₁'+d₂'.

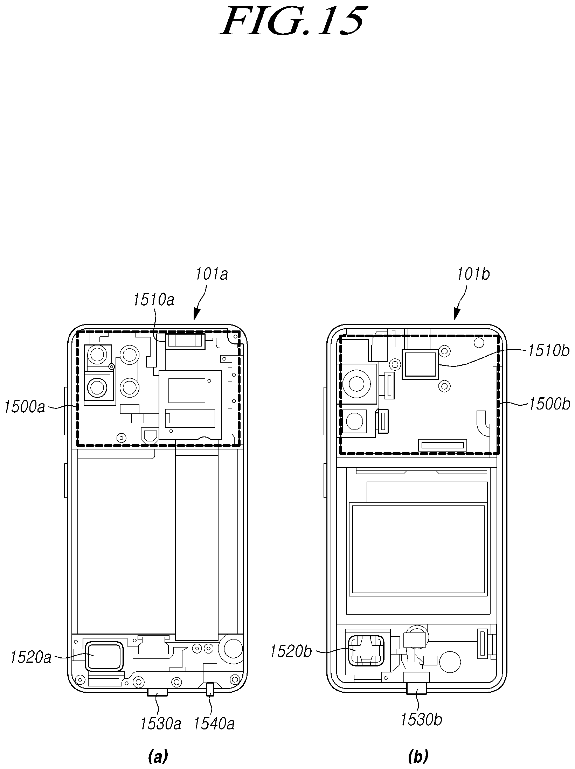

FIG. 15A and FIG. 15B is a plan diagram illustrating an electronic device (e.g., the electronic device 101 of FIG. 1) according to an embodiment of the disclosure.

Referring to FIG. 15A and FIG 15B, the electronic device 101 may include two types 101a and 101b. However, the disclosure is not limited thereto, and various types of structures may be included.

In FIG. 15A, the electronic device 101a may include a PCB 1500a, an upper receiver 1510a, a lower speaker 1520a, a usb terminal 1530a, and a 3.5 mm earphone terminal 1540a. The upper receiver 1510a may correspond to the first sound output 340-4a of FIG. 12. The upper receiver 1510a may correspond to the first sound output 340-5a of FIG. 13. The 3.5 mm earphone terminal 1540a may correspond to the second sound output 340-5b of FIG. 13. Various types of sound outputs (e.g., earphones, headphones, and speakers) may be connected to the second sound output 340-5b. The lower speaker 1520a may correspond to the second sound output 340-4b of FIG. 12. The lower speaker 1520a may correspond to the third sound output 340-5c of FIG. 13. The usb terminal 1530a may correspond to the third sound output 340-4c of FIG. 12. Various types of sound outputs (e.g., earphones, headphones, and speakers) may be connected to the third sound output 340-5c. The usb terminal 1530a may correspond to the fourth sound output 340-5d of FIG. 13. Various types of sound outputs (e.g., earphones, headphones, and speakers) may be connected to the fourth sound output 340-5d.

In FIG. 15B, the electronic device 101b may include a PCB 1500b, an upper speaker 1510b, a lower speaker 1520b, and an usb terminal 1530b. The upper speaker 1510b may correspond to the first sound output 340-4a of FIG. 12. The upper speaker 1510b may correspond to the first sound output 340-5a of FIG. 13. The lower speaker 1520b may correspond to the second sound output 340-4b of FIG. 12. The lower speaker 1520b may correspond to the third sound output 340-5c of FIG. 13. the usb terminal 1530b may correspond to the third sound output 340-4c of FIG. 12. Various types of sound outputs (e.g., earphones, headphones, and speakers) may be connected to the third sound output 340-5c. The usb terminal 1530b may correspond to the fourth sound output 340-5d of FIG. 13. Various types of sound outputs (e.g., earphones, headphones, and speakers) may be connected to the fourth sound output 340-5d. Further, the plurality of sound outputs included in the electronic devices 101a and 101b of FIG. 15A and FIG. 15B may correspond to the plurality of sound outputs 340-4a, 340-4b, and 340-4c of FIG. 12 or the plurality of sound outputs 340-5a, 340-5b, 340-5c, and 340-5d of FIG. 13 in various combinations.

An audio device (e.g., the audio device 300-2 of FIG. 4) according to an embodiment of the disclosure may include a processor (e.g., the processor 310-2 of FIG. 4) configured to output an audio signal. The audio device 300-2 may include an audio amplifier (e.g., the audio amplifier 320 of FIG. 4) configured to amplify and output the audio signal output from the processor 310-2 through an interface 350 electrically connected to the processor 310-2. The audio device 300-2 may include a switch part 330 (e.g., the switch part 330 of FIG. 4) configured to switch the amplified audio signal output from the audio amplifier 320 to a sound output (e.g., the sound output 340 of FIG. 4) in response to a switching control signal. The audio device 300-2 may include the sound output 340 configured to output the amplified audio signal transferred through the switch part 330 to an outside. The audio device 300-2 may include a rectifier (e.g., the rectifier 410 of FIG. 4) configured to output the switching control signal for enabling the switch part 330 if there is the audio signal transferred from the processor 310-2 to the audio amplifier 320 through the interface 350.

In the audio device 300-2 according to an embodiment of the disclosure, the rectifier 410 may be configured to rectify the audio signal transferred from the processor 310-2 to the audio amplifier 320 through the interface 350 into a signal having a DC voltage and output the signal as the switching control signal.

According to an embodiment of the disclosure, the audio device 300-3 (e.g., the audio device 300-3 of FIG. 6) may include an adjustment part 610 (e.g., the adjustment part 610 of FIG. 6) configured to adjust a voltage level of the DC voltage signal output from the rectifier 410 and transfer the DC voltage signal to the switch part 330.

In the audio device 300-3 according to an embodiment of the disclosure, the adjustment part 610 may be configured to boost or drop a level of the DC voltage signal output from the rectifier 410 and transfer the DC voltage signal to the switch part 330.

In the audio device 300b (e.g., the audio device 300b of FIG. 8B) according to an embodiment of the disclosure, the audio amplifier 320b and the rectifier 410 may be configured as one integrated circuit.

In the audio device 300a (e.g., the audio device 300a of FIG. 8A) according to an embodiment of the disclosure, the processor 310a (e.g., the processor 310a of FIG. 8A) and the rectifier 410 may be configured as one integrated circuit.

In the audio device 300c (e.g., the audio device 300c of FIG. 8C) according to an embodiment of the disclosure, the audio amplifier 320c (e.g., the audio amplifier 320c of FIG. 8C) and the switch part 330 may be configured as one integrated circuit.

In the audio device 300e (e.g., the audio device 800e of FIG. 8E) according to an embodiment of the disclosure, the audio amplifier 320e (e.g., the audio amplifier 320e of FIG. 8E), the rectifier 410, and the switch part 330 may be configured as one integrated circuit.

According to an embodiment of the disclosure, there may be various effects including an effect of detecting an audio signal and outputting a control signal EN/DIS for controlling the switch part 330 if there is the audio signal.

According to an embodiment of the disclosure, the audio device 300-2 may include various effects including an effect of blocking audible noise generated in the idle state from being output to the sound output 340.

In the audio device 300-4 (e.g., the audio device 300-4 of FIG. 12) according to an embodiment of the disclosure, the sound output 340-4a, 340-4b, and 340-4c (e.g., the first sound output 340-4a, the second sound output 340-4b, and the third sound output 340-4c of FIG. 12) may include a plurality of speakers (e.g., the first sound output 340-4a, the second sound output 340-4b, and the third sound output 340-4c of FIG. 12). In the audio device 300-4, the switch part 330-4a and 330-4b may include a plurality of switches (e.g., the first switch part 330-4a or the second switch part 330-4b of FIG. 12) configured to independently connect the plurality of speakers 340-4a, 340-4b, and 340-4c to the audio amplifier (e.g., the first audio amplifier 320-4a and the second audio amplifier 320-4b of FIG. 12). In the audio device 300-4, the rectifier 410 may be configured to output the switching control signal EN/DIS for controlling the plurality of switches 330-4a and 330-4b.

The audio device 300-5 (e.g., the audio device 300-5 of FIG. 13) according to an embodiment of the disclosure may include a signal divider 510 (e.g., the signal divider 510 of FIG. 13) configured to output a switching control signal EN/DIS for each of the plurality of switches 330-5a and 330-5b by the switching control signal EN/DIS output by the rectifier 410-5a (e.g., the first rectifier 410-5a of FIG. 13).

In the audio device 300-5 according to an embodiment of the disclosure, any one P₁₃ of the plurality of input terminals P₁₃ and P₃₀ of the signal divider 510 may be configured to be electrically connected to the rectifier 410-5a.

In the audio device 300-5 according to an embodiment of the disclosure, any one P₃₀ of the plurality of input terminals P₁₃ and P₃₀ of the signal divider 510 may be configured to be electrically connected to the processor 310-5.

In the audio device 300-5 according to an embodiment of the disclosure, any one P₃₀ of the plurality of input terminals P₁₃ and P₃₀ of the signal divider 510 may be configured to be electrically connected to the audio amplifier 320-5a.

In the audio device 300-5 according to an embodiment of the disclosure, the signal divider 510 may be a logic circuit configured to output a first switching control signal EN for enabling the first switch 330-5a included in the plurality of switches 330-5a and 330-5b and a second switch control signal DIS for disabling the second switch 330-5b included in the plurality of switches 330-5a and 330-5b by the switching control signal EN/DIS output by the first rectifier 410-5a.

The audio device 300 may include various effects including an effect of controlling to output a sound signal to only one speaker among the plurality of speakers.

A method for controlling an output of an audio signal by an electronic device 101 according to an embodiment of the disclosure may comprise obtaining an audio signal. The control method may comprise amplifying the obtained audio signal. The control method may comprise rectifying the obtained audio signal and outputting a switching control signal EN/DIS based on the rectified signal. The control method may comprise outputting the amplified audio signal based on the switching control signal.

In the method for controlling the output of the audio signal by the electronic device 101 according to an embodiment of the disclosure, the switching control signal EN/DIS may be a signal for controlling to enable (EN) or disable (DIS) the output of the amplified audio signal.

The method for controlling the output of the audio signal by the electronic device 101 according to an embodiment of the disclosure may comprise outputting the switching control signal EN/DIS to enable the output of the amplified audio signal if the rectified signal is a predetermined voltage or more.

The method for controlling the output of the audio signal by the electronic device 101 according to an embodiment of the disclosure may include outputting the switching control signal EN/DIS to disable the output of the amplified audio signal if the rectified signal is less than the predetermined voltage.

The method for controlling the output of the audio signal by the electronic device 101 according to an embodiment of the disclosure may comprise adjusting a voltage level of the rectified signal.

In the disclosure, an electronic device may comprise a non-transitory computer-readable storage medium storing one or more programs. The one or more programs stored in the computer-readable storage medium may include instructions enabling the electronic device to obtain a signal in an interface corresponding to an input for audio amplification. The one or more programs stored in the computer-readable storage medium may include instructions enabling the electronic device to output an amplified signal using the signal in the interface as an input. The one or more programs stored in the computer-readable storage medium may include instructions enabling the electronic device to connect a path for transferring the amplified signal to an output audio signal by a signal rectified from a signal obtained from the interface.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An audio device (300-2), comprising:
a processor (310-2) configured to output an audio signal;
an audio amplifier (320) configured to amplify and output the audio signal output from the processor (310-2) through an interface (350) electrically connecting the processor (310-2);
a switch part (330) configured to switch the amplified audio signal output from the audio amplifier (320) to a sound output (340) in response to a switching control signal (EN/DIS);
the sound output (340) configured to output the amplified audio signal transferred through the switch part (330) to an outside; and
a rectifier (410) configured to output the switching control signal (EN/DIS) for enabling or disabling the switch part (330) if there is the audio signal transferred from the processor (310-2) to the audio amplifier (320) through the interface (350).

2. The audio device of claim 1, wherein the rectifier (410) is configured to rectify the audio signal transferred from the processor (310-2) to the audio amplifier (320) through the interface (350) into a DC voltage signal and output the DC voltage signal as the switching control signal (EN/DIS).

3. The audio device of claim 2, further comprising an adjustment part (610) configured to adjust a voltage level of the DC voltage signal output from the rectifier (410) and transfer the DC voltage signal to the switch part (330).

4. The audio device of claim 3, wherein the adjustment part (610) boosts or drops the voltage level of the DC voltage signal output from the rectifier (410) and transfer the DC voltage signal to the switch part (330).

5. The audio device of any one of claims 1 to 4, wherein the audio amplifier (320b) and the rectifier (410) are configured as one integrated circuit.

6. The audio device of any one of claims 1 to 4, wherein the processor (310a) and the rectifier (410) are configured as one integrated circuit.

7. The audio device of any one of claims 1 to 4, wherein the audio amplifier (320c) and the switch part (330) are configured as one integrated circuit.

8. The audio device of any one of claims 1 to 4, wherein the audio amplifier (320e), the rectifier (410), and the switch part (330) are configured as one integrated circuit.

9. The audio device of claim 1, wherein the sound output (340) includes a plurality of speakers (340-4a, 340-4b, 340-4c),
wherein the switch part (330-4a, 330-4b) includes a plurality of switches (330-4a, 330-4b) configured to connect the plurality of speakers (340-4a, 340-4b) independently from the audio amplifier (320-4a), and
wherein the rectifier (410) is configured to output the switching control signal (EN/DIS) for controlling the plurality of switches (330-4a, 330-4b).

10. The audio device of claim 9, further comprising a signal divider (510) configured to output a switching control signal for each of the plurality of switches (330-5a, 330-5b) by the switching control signal (EN/DIS) output by the rectifier (410-5a).

11. The audio device of claim 9, further comprising a signal divider (510) configured to output a switching control signal for each of the plurality of switches (330-5a, 330-5b) by the switching control signal (EN/DIS) output by the rectifier (410-5a),
wherein any one (P₁₃) of a plurality of input terminals (P₁₃, P₃₀) of the signal divider (510) is electrically connected to the rectifier (410-5a).

12. The audio device of claim 9, further comprising a signal divider (510) configured to output a switching control signal for each of the plurality of switches (330-5a, 330-5b) by the switching control signal (EN/DIS) output by the rectifier (410-5a),
wherein any one (P₃₀) of a plurality of input terminals (P₁₃, P₃₀) of the signal divider (510) is electrically connected to the processor (310-5).

13. The audio device of claim 9, further comprising a signal divider (510) configured to output a switching control signal for each of the plurality of switches (330-5a, 330-5b) by the switching control signal (EN/DIS) output by the rectifier (410-5a),
wherein any one (P₃₀) of a plurality of input terminals (P₁₃, P₃₀) of the signal divider (510) is electrically connected to the audio amplifier (320-5a).

14. The audio device of claim 10, wherein the signal divider (510) is a logic circuit configured to output a first switching control signal (EN) for enabling a first switch (330-5a) included in the plurality of switches (330-5a, 330-5b) and a second switching control signal (DIS) for disabling a second switch (330-5b) included in the plurality of switches by the switching control signal (EN/DIS) output by the rectifier (410-5a).

15. A method for controlling an output of an audio signal by the electronic device (101) according to any one of claims 1 to 14, the method comprising:
obtaining an audio signal;
amplifying the obtained audio signal;
rectifying the obtained audio signal and outputting a switching control signal (EN/DIS) based on the rectified signal; and
outputting the amplified audio signal based on the switching control signal.
